# EUROPÄISCHE PATENTSCHRIFT

(11) **EP 3 513 201 B1**
(45) Veröffentlichungstag und Bekanntmachung des Hinweises auf die Patenterteilung: **15.07.2020**
(21) Anmeldenummer: 17777804.0
(22) Anmeldetag: 14.09.2017
(51) Int. Cl.: G01R 1/067

(54) **KONTAKTSTIFT, INSBESONDERE FEDERKONTAKTSTIFT**
CONTACT PIN, IN PARTICULAR SPRING CONTACT PIN
BROCHE DE CONTACT, NOTAMMENT BROCHE DE CONTACT À RESSORT

(30) Priorität: 14.09.2016 DE 102016217563
(43) Veröffentlichungstag der Anmeldung: 24.07.2019
(73) Patentinhaber: Feinmetall GmbH, 71083 Herrenberg (DE)
(72) Erfinder: KÖNIG, Christian, 70794 Filderstadt (DE); BURGOLD, Jörg, 71083 Herrenberg (DE); VOLKMANN, Gunnar, 64546 Mörfelden-Walldorf (DE); FLIK, Mark-Daniel, 72229 Rohrdorf (DE)
(74) Vertreter: Clarenbach, Carl-Philipp
(86) Internationale Anmeldenummer: PCT/EP2017/073179
(87) Internationale Veröffentlichungsnummer: WO 2018/050767

(56) Entgegenhaltungen:
- DE-U1- 20 315 894
- US-A1- 2014 266 278
- US-A1- 2016 178 665
- US-B1- 6 956 362

## Beschreibung

Die Erfindung betrifft einen Kontaktstift, insbesondere Federkontaktstift, mit einem Prüfkopf zur Berührungskontaktierung einer elektrisch leitfähigen Kontaktfläche eines Prüflings, insbesondere Leiterplatte, Steckereinrichtung oder dergleichen, und mit einer Stifthülse, in welcher der Prüfkopf mit einem Führungsende axial verschiebbar gelagert angeordnet ist.

Kontaktstifte und Federkontaktstifte der eingangs genannten Art sind aus dem Stand der Technik bereits bekannt. Üblicherweise weisen Federkontaktstifte eine kreiszylinderförmige Stifthülse, auch Mantel genannt, auf, die einen runden beziehungsweise kreisförmigen Querschnitt aufweist, und in welcher ein Prüfkopf zum elektrischen Kontaktieren eines Prüflings axial verlagerbar angeordnet ist. Dazu weist der Prüfkopf ein Führungsende auf, welches in die Stifthülse axial hineinragt und in der Stifthülse axial verschiebbar beziehungsweise längsverschieblich gelagert ist. Das Führungsende ist dabei unverlierbar in der Stifthülse gehalten, beispielsweise durch einen Bördelrand an einem Ende der Stifthülse, und wird vorzugsweise durch ein in der Stifthülse angeordnetes Federelement, insbesondere Schraubenfeder, in Richtung dieses Endes vorgespannt, sodass der Kontaktkopf aus der Stifthülse heraus gedrängt wird. Zum Kontaktieren des Prüflings wird der Federkontaktstift zu dem Prüfling bewegt, bis der Prüfkopf auf die zu kontaktierende Kontaktfläche des Prüflings trifft. Dadurch, dass der Prüfkopf verschiebbar in der Stifthülse gelagert ist, ergibt sich der Vorteil, dass der Prüfkopf einfedern kann. Hierdurch kann bei einer Prüfeinrichtung, die eine Vielzahl derartiger Kontaktstifte aufweist, eine sichere Kontaktierung aller elektrischen Kontaktflächen des Prüflings gewährleisten werden.

Der runde Querschnitt erschwert jedoch den Einsatz von elektrischen/elektronischen Bauteilen in der Stifthülse, durch welche der Funktionsumfang des Kontaktstifts erhöht werden könnte. So ist es beispielsweise nicht ohne Weiteres möglich, Bauteile oder Strukturen, die für das Bestücken von flachen Substraten beziehungsweise Leiterplatten verwendet werden, auch in einem Kontaktstift zu montieren. DE 203 15 894 U1 offenbart einen als Federkontaktstift ausgebildeten Hochstromstift.

Der Erfindung liegt daher die Aufgabe zugrunde, einen Kontaktstift, insbesondere Federkontaktstift, zu schaffen, welcher die Montage auch herkömmlicher elektrischer/elektronischer Bauteile an beziehungsweise in dem Kontaktstift auf einfache Art und Weise ermöglicht.

Die der Erfindung zugrunde liegende Aufgabe wird durch einen Kontaktstift mit den Merkmalen des Anspruchs 1 gelöst. Dieser hat den Vorteil, dass die Bauteile auf herkömmliche Art und Weise auf einem flachen Schaltungsträger montiert werden können, bevor der Schaltungsträger in der Stifthülse montiert wird, wobei der Schaltungsträger anschließend verformt wird, um vorteilhaft in die Stifthülse eingeschoben zu werden. Erfindungsgemäß wird dies dadurch erreicht, dass das Bauteil, das auch eine elektrisch leitfähige Struktur sein kann, auf einem zumindest abschnittsweise flexiblen Schaltungsträger, der insbesondere aus einem elektrisch isolierenden beziehungsweise nicht-leitfähigen Kunststoff gefertigt ist, angeordnet ist, wobei der Schaltungsträger durch Rollen und/oder Falten in die Stifthülse axial eingeschoben/einschiebbar ist. Die Endform des Schaltungsträgers wird somit erst nach dem Bestücken mit dem zumindest einen Bauteil hergestellt, sodass die Montage des Bauteils auf herkömmliche Art und Weise, wie auf einer flachen Leiterplatte erfolgen kann. Durch die zumindest abschnittsweise flexible Ausgestaltung des Schaltungsträgers lässt sich dieser nach der Montage des jeweiligen Bauteils in die gewünschte Form rollen und/oder falten und dadurch einfach in die Stifthülse axial einschieben. Dadurch ist die Anordnung des Bauteils in der Stifthülse einfach und kostengünstig erreichbar.

Gemäß einer bevorzugten Weiterbildung der Erfindung ist vorgesehen, dass der Schaltungsträger zumindest abschnittsweise eine Eigenelastizität aufweist, sodass der Schaltungsträger durch die Eigenelastizität in der Stifthülse zumindest bereichsweise gegen eine Innenseite der Stifthülse vorgespannt ist. Durch die Eigenelastizität wird erreicht, dass der Schaltungsträger innerhalb der Stifthülse radial verspannt ist, wodurch sich eine sichere Arretierung und Ausrichtung des Schaltungsträgers innerhalb der Stifthülse ergibt. Insbesondere wird durch die Vorsprünge erreicht, dass vorgesehene Bereiche des Schaltungsträgers stets beabstandet von der Innenseite der üblicherweise elektrisch leitfähigen Stifthülse angeordnet sind, sodass Kurzschlüsse sicher vermieden werden können. Darüber hinaus ist es durch die Vorspannung auch möglich, dass die Stifthülse selbst elektrisch sicher kontaktiert werden kann, indem der gegen die Stifthülse vorgespannte Abschnitt des Schaltungsträgers elektrisch leitfähig ausgebildet ist beziehungsweise ein elektrisch leitfähiges Kontaktelement aufweist.

Insbesondere ist dabei vorgesehen, dass der Schaltungsträger wenigstens eine elektrisch leitfähige Kontaktfläche aufweist, die gegen die Innenseite der Stifthülse vorgespannt/vorspannbar ist. Hierdurch wird auf einfache Art und Weise die elektrische Verbindung von dem Schaltungsträger und den darauf angeordneten elektrischen/elektronischen Bauteilen zu dem Prüfling durch die Stifthülse und den Prüfkopf des Kontaktstifts hergestellt. Dadurch ergibt sich eine sichere und einfache elektrische Verbindung, die es ermöglicht, mittels des Schaltungsträgers und den darauf angeordneten Bauteilen weitere Informationen bezüglich des Prüflings zu ermitteln oder Tests beziehungsweise Prüfungen an dem Prüfling durchzuführen. Durch die mechanische Vorspannung wird insbesondere erreicht, dass der elektrische Kontakt dauerhaft erhalten bleibt, auch wenn Vibrationen oder Beschleunigungen auf den Kontaktstift wirken.

Gemäß einer bevorzugten Weiterbildung der Erfindung ist vorgesehen, dass der Schaltungsträger zumindest abschnittsweise starr ausgebildet ist, wobei auf einem starren Abschnitt insbesondere das elektrische/elektronische Bauteil angeordnet ist. Der Schaltungsträger ist somit abschnittsweise elastisch verformbar beziehungsweise flexibel und abschnittsweise starr ausgebildet. Damit weist der Schaltungsträger Bereiche auf, welche beim Einrollen nicht verformt werden. An diesen starren Bereichen ist die Anordnung des einen oder mehrerer elektrischer/elektronischer Bauteile besonders vorteilhaft, weil durch die starre Ausführung des Schaltungsträgers in diesem Bereich die Verbindungsstellen zwischen dem Bauteil und dem Schaltungsträger, insbesondere auf dem Schaltungsträger angeordneter Leiterbahnen, bei einer Verformung der flexiblen Bereiche nicht mitverformt und damit nicht belastet werden. Der Schaltungsträger ist somit insbesondere in Trägerabschnitte, die starr ausgebildet sind, und Halteabschnitte oder Kontaktabschnitte, die flexibel, insbesondere elastisch verformbar ausgebildet sind, unterteilt. Gemäß einer weiteren Ausführungsform ist vorgesehen, dass der Schaltungsträger selbst nicht starr ausgebildet ist, jedoch durch das Anordnen eines oder mehrerer Bauteile, insbesondere Versteifungsbauteile, abschnittsweise versteift wird, sodass sich starre Abschnitte an dem Schaltungsträger durch daran angeordnete Bauteile ergeben.

Weiterhin ist bevorzugt vorgesehen, dass zumindest ein starrer Abschnitt des Schaltungsträgers beabstandet zu der Innenseite der Stifthülse angeordnet/anordenbar ist. Der Schaltungsträger ist somit derart geformt, dass wenn er von der flachen Ausgangsform in die gerollte oder gefaltete Form, insbesondere beim Einschieben in die Stifthülse, überführt wird, der zumindest eine starre Bereich beabstandet zu der Innenseite liegt, sodass darauf befindliche Elemente beziehungsweise Bauteile vorzugsweise ebenfalls beabstandet von der Innenseite liegen. Hierdurch wird sichergestellt, dass zwischen den Bauteilen oder den starren Bereichen des Schaltungsträgers keine unerwünschten Kurzschlüsse zu dem Mantel beziehungsweise der Stifthülse im Betrieb entstehen. Darüber hinaus wird durch die beabstandete Anordnung auch erreicht, dass auf dem jeweiligen Abschnitt des Schaltungsträgers Bauteile zwischen Schaltungsträger und Stifthülse anordenbar sind, insbesondere derart, dass kein Berührungskontakt zu der Stifthülse entsteht, um auch eine mechanische Belastung der Bauteile zu vermeiden.

Gemäß einer vorteilhaften Weiterbildung der Erfindung ist außerdem vorgesehen, dass der Schaltungsträger auf seiner der Innenseite zugewandten Oberfläche zumindest bereichsweise eine elektrisch isolierende Schicht aufweist. Damit ist der Schaltungsträger elektrisch zu der Stifthülse zumindest bereichsweise isoliert, sodass er bereichsweise an der Innenseite der Stifthülse anliegen kann, ohne dass eine elektrische Verbindung entsteht. Die elektrisch isolierten und an der Innenseite anliegenden Bereiche des Schaltungsträgers, die insbesondere gegen die Stifthülse vorgespannt sind, dienen damit allein zur Arretierung und Befestigung des Schaltungsträgers in der Stifthülse. Zwischen der isolierenden Schicht und dem Schaltungsträger selbst können eine oder mehrere Leiterbahnen verlaufen, die durch die elektrisch isolierende Schicht vor einem elektrischen Kontakt mit der Stifthülse geschützt sind. Zweckmäßigerweise erstreckt sich die isolierende Schicht im Wesentlichen über die gesamte Oberfläche des Schaltungsträgers und fehlt nur an den Stellen, an welchen ein Kontakt zu der Stifthülse, den Bauteilen oder anderen Abschnitten, die zur elektrischen Kontaktierung ausgebildet sind, gewünscht ist. Bei der elektrisch isolierenden Schicht kann es sich beispielsweise um eine Isolationsfolie oder um einen nachträglich aufgebrachten elektrisch isolierenden Lack, beispielsweise Lötstopplack, handeln. Auch ist es möglich, die Beschichtung nur dort aufzubringen, wo elektrisch leitfähige Elemente auf dem Schaltungsträger vorhanden sind. Die Beschichtung kann dabei auch mechanisch unterstützend für die insbesondere starren Bereiche des Schaltungsträgers wirken oder beispielsweise die starren Bereiche des Schaltungsträgers definieren. Der Schaltungsträger selbst kann damit homogen ausgebildet sein, wobei die starren Bereiche durch die isolierende Schicht und/oder die auf dem Schaltungsträger angeordneten Bauteile oder Leiterbahnen gebildet werden.

Weiterhin ist bevorzugt vorgesehen, dass der Schaltungsträger kreisringförmig, dreieckförmig oder S-förmig gerollt/rollbar beziehungsweise gefaltet/faltbar ist. Aufgrund seiner Flexibilität kann dar Schaltungsträger in viele unterschiedliche Formen gerollt oder gefaltet werden. Je nach gewünschtem Funktionsumfang können sich dabei unterschiedliche Formen anbieten. Insbesondere unterscheiden sich die Formen in Abhängigkeit der verwendeten Bauteile und deren Anzahl zueinander. Insbesondere in Bereichen, in welchen ein Bauteil auf der der Innenwand zugewandten Oberfläche beziehungsweise Seitenfläche des Schaltungsträgers angeordnet ist, weicht der Schaltungsträger bevorzugt von der Kreisringform ab, um den notwendigen Platz für das Bauteil zwischen Schaltungsträger und Stifthülse zu bieten. Insbesondere durch die Dreiecksform können mehrere Bauteile an der der Innenseite der Stifthülse zugewandten Oberfläche beziehungsweise auf der der Innenseite gegenüberliegenden Oberfläche des Schaltungsträgers angeordnet werden. Insbesondere ist vorgesehen, dass Bauteile allein zur Versteifung des Schaltungsträgers an diesem angeordnet sind, beispielsweise, um dessen Form in der Stifthülse zu bestimmen und dauerhaft zu gewährleisten. Die kreisringförmige Verformung eignet sich beispielsweise dazu, mehrere Bauteile an der Außenseite und/oder Innenseite des Schaltungsträgers anzuordnen. Insbesondere wird ein verhältnismäßig großer Innenraum zur Verfügung gestellt, in welchem auch größere Bauteile angeordnet werden können. Die Dreiecksform eignet sich insbesondere dazu, eine Vielzahl von Bauteilen auf der Außenseite beziehungsweise auf der der Innenseite zugewandten Oberfläche des Schaltungsträgers anzuordnen. Bei der S-förmigen Ausgestaltung ergibt sich ein mittlerer Quersteg, der beidseitig mit Bauteilen besetzt werden kann.

Gemäß einer bevorzugten Weiterbildung der Erfindung ist vorgesehen, dass der Schaltungsträger einen kreisförmigen, insbesondere starren Trägerabschnitt für das zumindest eine Bauteil aufweist, von dem zumindest ein streifenförmiger Kontaktabschnitt ausgeht, der durch das Falten des Schaltungsträgers senkrecht zu dem Trägerabschnitt ausgerichtet/ausrichtbar ist, um zumindest im Wesentlichen parallel zu der Längserstreckung der Stifthülse in der Stifthülse zu liegen, und wobei der Trägerabschnitt einen Außendurchmesser aufweist, der kleiner ist als der Innendurchmesser der Stifthülse. Der Trägerabschnitt des Schaltungsträgers kann somit derart in die Stifthülse eingeschoben werden, dass der Trägerabschnitt senkrecht zur Längsmittelachse der Stifthülse ausgerichtet ist, sich also radial in der Stifthülse erstreckt. Damit bildet der Trägerabschnitt eine Stirnseite des Schaltungsträgers, auf welcher ein oder mehrere Bauteile angeordnet werden können. Dadurch ist es beispielsweise auf einfache Art und Weise möglich, einen Sensor als Bauteil auf dem Trägerabschnitt in der Stifthülse derart anzuordnen, dass der Sensor axial beziehungsweise in Längsrichtung der Stifthülse sensiert, beispielsweise in Form eines berührungsfrei arbeitenden Abstandssensors. Bevorzugt wird der Trägerabschnitt dadurch derart ausgebildet, dass auf der von dem Sensor abgewandten Seite des Trägerabschnitts ein Versteifungselement an dem Trägerabschnitt angeordnet ist, wobei es sich bei dem Versteifungselement ebenfalls um ein elektrisches/elektronisches Bauteil handeln kann. Durch den streifenförmigen Kontaktabschnitt, der durch das Falten senkrecht zum Trägerabschnitt ausgerichtet ist, ist eine elektrische Kontaktierung des auf dem Trägerabschnitt angeordneten Bauteils auch entfernt von dem Trägerabschnitt auf einfache Art und Weise möglich. Bevorzugt gehen von dem Trägerabschnitt zwei der streifenförmigen Kontaktabschnitte aus, die sich parallel und beabstandet zueinander in der Stifthülse erstrecken und jeweils mit einer elektrisch leitfähigen Leiterbahn versehen sind, um das Bauteil auf dem Trägerabschnitt elektrisch zu kontaktieren. An den freien Enden der streifenförmigen Kontaktabschnitte können diese jeweils elektrisch kontaktiert werden, um das Bauteil auf den Trägerabschnitt zu betreiben.

Zweckmäßigerweise weist der jeweilige Kontaktabschnitt auf seiner von der Innenseite der Stifthülse abgewandten Oberfläche wenigstens eine elektrisch leitfähige Leiterbahn auf. Damit ist die jeweilige Leiterbahn dem Innenraum der Stifthülse zugewandt und elektrisch von der Stifthülse durch den Schaltungsträger selbst isoliert. Hierdurch ist eine sichere und einfache Führung der Leiterbahn in der Stifthülse gewährleistet. Zweckmäßigerweise ist der Schaltungsträger dabei derart gefaltet/gerollt, dass die Kontaktabschnitte gegen die Innenseite der Stifthülse elastisch vorgespannt sind. Hierdurch wird verhindert, dass die auf der Innenseite der Kontaktabschnitte liegenden Leiterbahnen miteinander in Berührungskontakt gelangen können. Darüber hinaus wird der Trägerabschnitt durch die Vorspannung in der Stifthülse vorteilhaft ausgerichtet und arretiert.

Gemäß einer bevorzugten Weiterbildung der Erfindung ist vorgesehen, dass der Schaltungsträger, insbesondere der jeweilige streifenförmige Kontaktabschnitt, an einem freien, insbesondere ungerollten/ungefalteten Ende eine Struktur für eine Leiterplattensteckverbindung bildet. Damit ist der Kontaktabschnitt an seinem freien Ende besonders einfach elektrisch kontaktierbar, indem ein entsprechender Kontaktstecker beispielsweise auf den Kontaktabschnitt aufgesteckt wird. Vorzugsweise weist auch der kreisförmig, dreieckförmig oder S-förmig in der Stifthülse angeordnete Schaltungsträger wenigstens einen streifenförmigen Kontaktabschnitt auf, der insbesondere nicht gerollt oder gefaltet ist und an seinem freien Ende den elektrischen Anschlussstecker bildet.

Weiterhin ist bevorzugt vorgesehen, dass der Schaltungsträger wenigstens eine erste Einführschräge aufweist, durch welche ein Einrollen des Schaltungsträgers beim Einschieben in die Stifthülse erfolgt oder zumindest unterstützt wird. Die Einführschräge ist zweckmäßigerweise an dem Ende des Schaltungsträgers ausgebildet, welches zuerst in die Stifthülse eingeschoben wird. Der in seiner Ausgangsform insbesondere flache Schaltungsträger weist somit an einem Ende die erste Einführschräge auf, die beim Einschieben in die Stifthülse dafür sorgt, dass der Schaltungsträger eingerollt wird. Hierdurch ist eine einfache Montage des Schaltungsträgers gewährleistet, bei welcher der Schaltungsträger erst beim Einführen in die Stifthülse die gewünschte Endform erhält. Insbesondere bei einem zumindest im Wesentlichen kreisringförmig in der Stifthülse angeordneten Schaltungsträger ist dies von Vorteil.

Gemäß einer bevorzugten Weiterbildung der Erfindung ist vorgesehen, dass die Stifthülse zumindest eine zweite Einführschräge, insbesondere Fase, an einem axial offenen Ende aufweist, durch welches der Schaltungsträger in die Stifthülse eingeschoben/einschiebbar ist. Die zweite Einführschräge an der Stifthülse erleichtert das Einschieben und Verformen des Schaltungsträgers. Insbesondere ist die zweite Einführschräge als Fase ausgebildet, sodass die Stifthülse an diesem Ende einen sich zum Ende hin erweiternden Querschnitt aufweist. Diese Fase beziehungsweise Einführfase hilft bei der Zentrierung und Ausrichtung des Schaltungsträgers zu der Stifthülse beim Einführen des Schaltungsträgers.

Weiterhin ist bevorzugt vorgesehen, dass der Schaltungsträger zum Bilden eines Schaltkontaktstifts oder eines Linear-Potentiometers zumindest eine in Längserstreckung der Stifthülse verlaufende elektrische Kontaktbahn aufweist, die durch ein in der Stifthülse durch den Prüfkopf verlagerbares Kontaktelement in zumindest einer Schiebestellung des Prüfkopfes zu der Stifthülse elektrisch kontaktiert ist. Das Kontaktelement wird also innerhalb der Stifthülse durch den Prüfkopf verlagert. Dazu ist das Kontaktelement mit dem Prüfkopf, insbesondere mit dem Führungsende des Prüfkopfs mechanisch verbunden. Insbesondere ist vorgesehen, dass das Führungsende das Kontaktelement bildet oder zumindest mitbildet. Wird der Prüfkopf entgegen der Kraft des Federelements belastet und in Richtung der Stifthülse verlagert, sodass das Führungsende weiter in die Stifthülse hinein bewegt wird, so wird das Kontaktelement entlang der Kontaktbahn bewegt. In Abhängigkeit von der Schiebestellung des Prüfkopfs erfolgt somit eine elektrische Kontaktierung der Kontaktbahn durch das Kontaktelement. Gemäß einer ersten Ausführungsform ist die Kontaktbahn als unterbrochene Leiterbahn ausgebildet und weist dazu mehrere voneinander beabstandet ausgebildete elektrische Kontaktabschnitte auf, die durch elektrisch isolierte Abschnitte voneinander getrennt sind. Dadurch ist auf einfache Art und Weise ein Schaltkontaktstift realisiert, bei welchem das Kontaktelement in Abhängigkeit von der Schiebestellung des Prüfkopfs einen elektrischen Kontaktabschnitt oder einen isolierenden Abschnitt der Kontaktbahn kontaktiert. Alternativ ist die Kontaktbahn bevorzugt als Widerstandsbahn ausgebildet, die von dem Kontaktelement dauerhaft elektrisch berührungskontaktiert wird. In Abhängigkeit von der Schiebestellung verändert sich der elektrische Widerstand der Kontaktbahn, wodurch die Schiebeposition des Prüfkopfs auf einfache Art und Weise feststellbar ist.

Weiterhin ist bevorzugt vorgesehen, dass das Kontaktelement wenigstens ein Federelement aufweist, das eine elektrisch leitfähige Kontaktfläche des Kontaktelements radial zur Kontaktierung der Kontaktbahn vorspannt. Durch das Federelement wird gewährleistet, dass die Kontaktfläche stets gegen die Kontaktbahn gedrängt wird und ein Berührungskontakt zwischen Kontaktelement beziehungsweise Kontaktfläche und Kontaktbahn dauerhaft gewährleistet ist. Bei dem Federelement kann es sich beispielsweise um eine Schraubenfeder, Tellerfeder oder Blattfeder handeln. Bevorzugt bildet das Federelement selbst die Kontaktfläche aus beziehungsweise ist einstückig mit dieser ausgebildet. Dadurch ergibt sich eine kompakte Bauform, welche auch die Montage des Kontaktstifts erleichtert. Insbesondere ist das Federelement in einer in dem Führungsende ausgebildeten Querbohrung angeordnet. Insbesondere steht das Federelement dabei beidseitig von der Querbohrung vor und weist an jedem ihrer Enden jeweils eine der elektrischen Kontaktflächen auf, die jeweils eine Kontaktbahn des Schaltungsträgers berührungskontaktiert. Insbesondere ist der Kontaktstift derart ausgebildet, dass dann, wenn durch das Federelement die beiden Kontaktbahnen elektrisch miteinander verbunden sind, ein elektrischer Kreis geschlossen ist, und dann, wenn eine der Kontaktflächen auf einen elektrisch isolierten Abschnitt trifft, der elektrische Kreis geöffnet beziehungsweise unterbrochen ist. Hierdurch ist die Funktion eines Schaltkontaktstifts auf einfache Art und Weise realisiert. Alternativ ist das Kontaktelement bevorzugt als starres Kontaktelement, insbesondere als Kugelschleifer ausgebildet. Der Kugelschleifer ist ein zumindest im Wesentlichen kugelförmig ausgebildetes Element, das in der Stifthülse durch den Prüfkopf, gegebenenfalls entgegen der Kraft des Federelements, verlagerbar ist. Dazu ist der Kugelschleifer beispielsweise zwischen dem Federelement und dem Prüfkopf axial verspannt gelagert. Der Kugelschleifer ist in dauerhaftem Berührungskontakt mit einer oder mehreren Kontaktbahnen auf der Innenseite der Stifthülse, die insbesondere, wie zuvor beschrieben, durch den Schaltungsträger zur Verfügung gestellt werden. Der dauerhafte Berührungskontakt wird dabei insbesondere durch die Vorspannung des Schaltungsträgers realisiert. Dazu ist für diese Ausführungsform bevorzugt vorgesehen, dass die die Kontaktbahn oder -bahnen aufweisenden streifenförmigen Kontaktabschnitte elastisch aufeinander zu vorgespannt sind, um den dauerhaften Berührungskontakt zu gewährleistet. Dadurch kann auf separate Federn verzichtet und als bewegliches Kontaktelement der starre Kugelschleifer verwendet werden.

Weiterhin ist bevorzugt vorgesehen, dass das zumindest eine elektrische/elektronische Bauteil als optoelektronisches Bauteil, als Leuchtmittel, Sensor, Schalter und/oder als elektrischer Widerstand ausgebildet ist. Die Art und Verwendung des jeweiligen Bauteils ist variabel und es lassen sich aufgrund der vorteilhaften Gestaltung des Kontaktstifts viele unterschiedliche elektrische/elektronische Bauteile in dem Kontaktstift anordnen und verwenden. Je nach Anforderungsprofil an den Kontaktstift und dessen Einsatz können geeignete Bauteile gewählt werden, die zu unterschiedlichen Vorteilen und Möglichkeiten bei der Verwendung des Kontaktstifts führen.

Im Folgenden soll die Erfindung anhand der Zeichnung näher erläutert werden. Dazu zeigen
- Figur 1: einen bekannten Federkontaktstift in einer Längsschnittdarstellung,
- Figur 2: eine vorteilhafte Weiterbildung des Federkontaktstifts mit einem flexiblen Schaltungsträger vor der Montage,
- Figur 3: den Federkontaktstift mit dem flexiblen Schaltungsträger nach der Montage in einer Längsschnittdarstellung,
- Figur 4: den Federkontaktstift mit dem flexiblen Leitungsträger in einer Querschnittsdarstellung,
- Figur 5: den Federkontaktstift mit einer weiteren bespielhaften Ausbildung des Schaltungsträgers,
- Figur 6: den Federkontaktstift mit einer weiteren beispielhaften Ausbildung des Schaltungsträgers,
- Figur 7: den Federkontaktstift mit einer weiteren beispielhaften Ausbildung des Schaltungsträgers,
- Figur 8: eine vorteilhafte Ausführung des Schaltungsträgers gemäß einem weiteren Ausführungsbeispiel,
- Figur 9: ein weiteres Ausführungsbeispiel des Federkontaktstifts,
- Figur 10: ein Ausführungsbeispiel des Federkontaktstifts als Schaltkontaktstift,
- Figur 11: ein weiteres Ausführungsbeispiel des Federkontaktstifts als Schaltkontaktstift,
- Figur 12: ein Ausführungsbeispiel des Schaltungsträgers als Linear-Potentiometer,
- Figur 13: ein Ausführungsbeispiel des Federkontaktstifts mit einem Leuchtmittel und
- Figur 14: ein weiteres Ausführungsbeispiel des Federkontaktstifts mit dem einen Anschlussstecker aufweisenden Schaltungsträger.

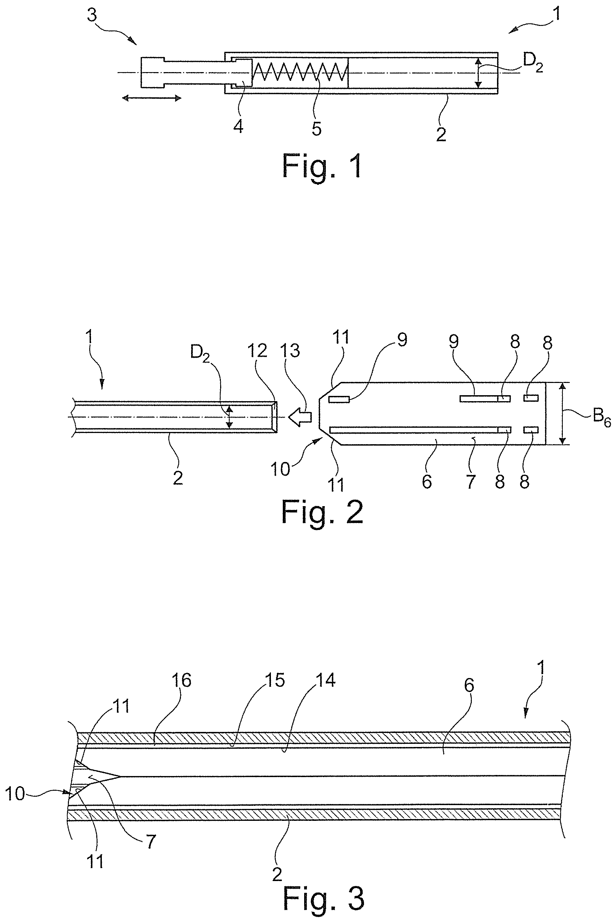

Figur 1 zeigt in einer vereinfachten Längsschnittdarstellung einen Federkontaktstift 1, der zur Berührungskontaktierung einer elektrisch leitfähigen Kontaktfläche eines hier nicht dargestellten Prüflings ausgebildet ist. Bei dem Prüfling kann es sich beispielsweise um einen Wafer, eine Leiterplatte oder dergleichen handeln. Der Federkontaktstift 1 weist eine kreiszylinderförmige Stifthülse 2 auf, in welcher ein Prüfkopf 3 zur Berührungskontaktierung mit einem Führungsende 4 axial verschiebbar gelagert ist. Auf das Führungsende 4 wirkt außerdem die Federkraft eines Federelements 5, das sich einendig an dem Prüfkopf 3 und anderendig an der Stifthülse 2 abstützt, um den Führungskopf 3 axial an seinem freien Ende aus der Stifthülse 2 heraus zu drängen. An dem dem Prüfkopf 3 gegenüberliegenden Ende ist die Stifthülse 2 mit einer Auswerteschaltung elektrisch verbindbar, sodass elektrische Messsignale durch den elektrisch leitfähigen Prüfkopf 3 und die elektrisch leitfähige Stifthülse 2 erfasst werden können. Durch die Berührungskontaktierung zwischen Prüfkopf 3 und Stifthülse 2 ist somit die elektrische Verbindung von dem Prüfling zu der Auswerteschaltung gewährleistet.

Wie üblich weist der Federkontaktstift 1 einen kreisringförmigen Querschnitt auf, wobei sich aufgrund der steigenden Funktionalität von elektrischen Geräten und der damit einhergehenden, notwendigen Miniaturisierung elektronischer Komponenten eine Notwendigkeit immer kleiner werdender Federkontaktstifte ergibt. Obwohl die Integration von elektrischen Funktionen, wie beispielsweise sensorische Aufgaben oder dergleichen, in den Federkontaktstift 1 angestrebt werden, zeigt sich, dass der kreisförmige Querschnitt ungünstig für die Integration elektrischer/elektronischer Bauteile ist, und dass die Stifthülse, die notwendigerweise aus elektrisch leitfähigem Material gefertigt ist, als Fehlerquelle für Kurzschlüsse mit elektrischen/elektronischen Bauteilen kaum zu vermeiden ist. Durch die im Folgenden beschriebenen Ausführungsbeispiele und vorteilhafter Weiterbildung des Federkontaktstifts 1 werden diese Probleme kostengünstig und sicher behoben.

Figur 2 zeigt dazu in einer vergrößerten Detailansicht, das von dem Prüfkopf 3 abgewandte Ende der Stifthülse 2, sowie einen in die Stifthülse 2 einzuschiebenden/einschiebbaren Schaltungsträger 6. Die Stifthülse 2 weist einen Innendurchmesser D₂ auf, der kleiner ist als die Breite B₆ des Schaltungsträgers 6 vor dem Einschieben in die Stifthülse 2. Gemäß dem vorliegenden Ausführungsbeispiel ist der Schaltungsträger 6 als flexibler Schaltungsträger ausgebildet, der in einem neutralen beziehungsweise entspannten Zustand vor der Montage plattenförmig vorliegt und auf einer ersten Seitenfläche 7 mehrere elektrisch leitfähige Kontaktflächen 8 sowie Leiterbahnen 9 aufweist. Die Höhe des Schaltungsträgers 6 ist im Vergleich zu seiner Breite B₆ und seiner Länge sehr viel kleiner ausgebildet, um die plattenförmige Ausgestaltung zu erhalten. Auf den Leiterbahnen 9 und Kontaktflächen 8 können elektrische/elektronische Bauteile montiert und elektrisch kontaktiert werden. Optional sind die Leiterbahnen 9 und Kontaktflächen 8 ebenfalls flexibel beziehungsweise elastisch verformbar ausgebildet.

An einer Stirnseite 10 weist der Schaltungsträger 6, der ansonsten eine rechteckförmige Kontur aufweist, keilförmige Einführschrägen 11 auf, die dazu führen, dass sich die Breite B₆ zu der Stirnseite 10 hin verringert. Die Stifthülse 2 weist an ihrem von dem Prüfkopf 3 abgewandten Ende ebenfalls eine Einführschräge 12 auf, die in Form einer umlaufenden Fase vorliegt, welche den Durchmesser D₂ zum Ende der Stifthülse 2 hin vergrößert.

Für die Montage des Federkontaktstifts 1 wird nun der Schaltungsträger 6 axial in die Stifthülse 2 eingeschoben, wie durch einen Pfeil 13 gezeigt. Zweckmäßigerweise ist die Breite des Schaltungsträgers 6 an seiner schmalsten Stelle der Stirnseite 10 kleiner als der größte Innendurchmesser der Einführschräge 12, sodass beim axialen Einschieben des Schaltungsträgers in Richtung seiner Längsachse in die Stifthülse 2 hinein die Einführschrägen 11 und 12 aufeinander treffen. Der Schaltungsträger 6 wird dabei außermittig in die Stifthülse 2 eingeführt, sodass die Einführschrägen 12 und 11 dazu führen, dass der flexible, insbesondere elastisch verformbare Schaltungsträger 6, beim Einschieben gemäß Pfeil 13 eingerollt wird.

Figur 3 zeigt dazu eine Längsschnittdarstellung der Stifthülse 2 mit dem darin eingerollten Schaltungsträger 6 nach der Montage. Die Breite B₆ des Schaltungsträgers 6 ist dabei derart gewählt, dass die Längskanten des Schaltungsträgers 6 im zusammengerollten Zustand nur mit geringem Abstand zueinander einander gegenüberliegen oder aneinander anliegen. Durch die vorteilhafte Eigenelastizität des Schaltungsträgers 6 legt sich dieser mit seiner der Seitenfläche 7 abgewandten Seitenfläche 14 an die Innenseite 15 der Stifthülse 2 an. Um einen direkten elektrischen Kontakt zu vermeiden, ist zweckmäßigerweise auf der Rückseite beziehungsweise der Seitenfläche 14 des Schaltungsträgers 6 wenigstens eine elektrisch isolierende Schicht 16 angeordnet oder ausgebildet, die in Figur 3 geschnitten gezeigt ist, sodass die gegebenenfalls sich bis auf die Rückseite des Schaltungsträgers 6 erstreckenden Leiterbahnen 9 oder Kontaktflächen 8 elektrisch gegenüber der elektrisch leitfähigen Stifthülse 2 isoliert sind. Durch die vorteilhafte Ausgestaltung ist somit der Schaltungsträger 6 auf einfache Art und Weise montierbar und insbesondere mit elektrischen/elektronischen Bauteilen versehen in der Stifthülse 2 anordenbar, wobei insbesondere durch Eigenelastizität ein sicheres Anlegen des Schaltungsträgers 6 in der Stifthülse 2 sowie eine die Stützanordnung der Bauteile innerhalb der Stifthülse 2 gewährleistet ist.

Der Schaltungsträger 6 mit einem oder mehreren elektrischen/elektronischen Bauteilen erfolgt zweckmäßigerweise im flachen Zustand des Schaltungsträgers 6, wie in Figur 2 gezeigt. Dadurch können standardisierte Bestückungsverfahren, wie beispielsweise SMD-Bestückung oder Dichtschicht-Technologien, genutzt werden. Der Schaltungsträger 6 weist vorzugsweise einen Kern aus flexibler Kunststofffolie (Polyamide) auf, auf welchen die Leiterbahnen 9 und Kontaktflächen 8, insbesondere aus Kupfer, welches optional beschichtet ist, aufgebracht sind. Optional kann auch ein Lötstopplack als zusätzlicher elektrischer Isolator sowie für eine erleichterte, gut definierte Verzinnung von beispielsweise den SMD-Kontaktflächen (8) oder - pads auf dem Schaltungsträger 6 genutzt werden. Auch die elektrisch isolierende Schicht 16 kann beispielsweise aus Lötstopplack gefertigt sein.

Während gemäß dem vorliegenden Ausführungsbeispiel der Einführschrägen 11 und 12 ein einfaches Einrollen beim Einschieben des Schaltungsträgers 6 gewährleisten, ist selbstverständlich auch eine Ausgestaltung möglich, bei welcher auf die Einführschrägen 11 und/oder 12 verzichtet wird. Dann ist es jedoch notwendig, dass der Schaltungsträger 6 vor dem Einschieben bereits durch ein separates Werkzeug in die aufgerollte/eingerollte Form verbracht wird.

Durch die Eigenelastizität wird somit eine definierte Ausrichtung des Schaltungsträgers 6 in der Stifthülse 2 sowie der darauf befindlichen elektronischen Bauteile gewährleistet. Ist der Schaltungsträger 6, wie zuvor bereits beschrieben, aus Kunststoff gefertigt, so kann auch auf die zusätzliche elektrisch isolierende Schicht 16 verzichtet werden, weil ein elektrischer Kontakt dann durch den Schaltungsträger 6 bereits zu der Stifthülse 2 verhindert ist.

Der Schaltungsträger 6 weist bevorzugt wenigstens einen starren und wenigstens einen flexibel verformbaren beziehungsweise elastisch verformbaren Abschnitt auf. Vorliegend werden auch die eigentlich flexiblen Abschnitte, auf denen elektrisch leitfähige Elemente, wie beispielsweise die Leiterbahn 9 oder Kontaktflächen 8, und/oder ein Lötstopplack aufgebracht sind, als starr angenommen, weil diese Abschnitte durch die aufgebrachten Elemente versteift werden. Alternativ ist auch denkbar, starre Abschnitte bereits bei der Fertigung des Schaltungsträgers 6 selbst auszubilden, sodass diese auch unabhängig von der Bestückung des Schaltungsträgers 6 im Vergleich zu anderen Abschnitten starr beziehungsweise steif ausgebildet sind. Hierdurch werden bewusst Abschnitte oder Bereiche geschaffen, welche sich durch ihre mechanischen Eigenschaften (Steifigkeit) beim Einschieben des Schaltungsträgers 6 in die Stifthülse 2 nicht verformen. Dadurch ist gewährleistet, dass auf diesen Bereichen/Abschnitten befindlichen Bauteile und/oder Elemente beim Einschieben nicht zusätzlich mechanisch belastet werden. Damit sind diese Bereiche/Abschnitte dazu geeignet, nicht flexible Bauteile aufzunehmen.

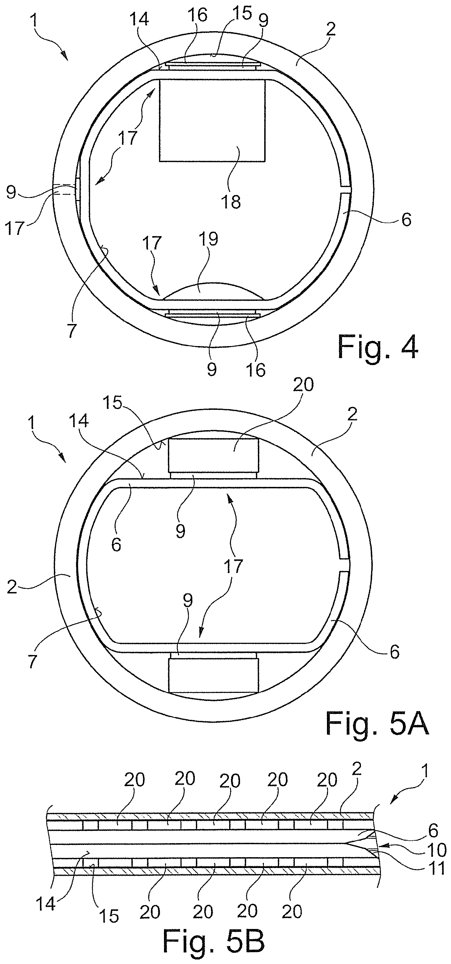

Figur 4 zeigt eine Querschnittsdarstellung des Federkontaktstifts 1 im Bereich des darin montierten Schaltungsträgers 6. Der Schaltungsträger 6 weist an seiner der Innenseite 16 der Stifthülse 2 zugewandten Seitenfläche 14 in diesem Ausführungsbeispiel mehrere Leiterbahnen 9 auf, die sich in Längserstreckung des Schaltungsträgers beziehungsweise der Stifthülse 2 erstrecken. Zwei der Leiterbahnen 9 sind außerdem mit der elektrisch isolierenden Schicht 16 versehen, sodass ein elektrischer Kontakt zwischen den außenliegenden Leiterbahnen 9 und der elektrisch leitfähigen Stifthülse 2 sicher verhindert ist. Die Leiterbahn 9 und die elektrisch isolierende Schicht 16 führen dabei zu einer Versteifung des Schaltungsträgers 6, sodass sich zwei zumindest im Wesentlichen starre Abschnitte 17 in dem Schaltungsträger 6 ergeben, die beim Einschieben in die Stifthülse 2 nicht mitverformt werden.

Die dritte der Leiterbahnen 9 ist nicht mit einer elektrisch isolierenden Schicht 16 versehen, sodass die Leiterbahn 9 direkt an der Innenseite 15 der Stifthülse 2 anliegt. Dadurch wird ein elektrischer Kontakt zwischen dem Schaltungsträger 6 und der Stifthülse 2 hergestellt. Aufgrund der Elastizität des Schaltungsträgers 6 wird auch diese Leiterbahn 9 radial nach außen gegen die Innenseite 15 der Stifthülse 2 gedrängt, sodass der elektrische Kontakt dauerhaft aufrechterhalten bleibt. Optional ist in der Stifthülse 2 im Bereich der dritten Leiterbahn 9 eine Öffnung 17 ausgebildet (gestrichelt dargestellt), beispielsweise in Form einer Radialbohrung, in welche beispielsweise ein Lot zur stoffschlüssigen Verbindung von der dritten Leiterbahn 9 und der Stifthülse 2 von außen eingebracht werden kann. Dadurch würde auch der Schaltungsträger 6 in der Stifthülse 2 zusätzlich arretiert werden. Durch den direkten elektrischen Kontakt zwischen der dritten Leiterbahn 9 und der Stifthülse 2 ist außerdem auch eine gute thermische Anbindung des Schaltungsträgers 6 an die Stifthülse 2 gewährleistet. Durch den elektrischen Kontakt kann beispielsweise ein Testsignal/Messsignal vom Prüfkopf 3 direkt in die auf dem Schaltungsträger 6 angeordnete Schaltung eingeleitet werden.

Durch die mit einer elektrisch isolierenden Schicht 16 versehenden Leiterbahnen 9, die im Vergleich zu der dritten Leiterbahn 9 breiter ausgebildet sind, ergibt sich, dass die starren Bereiche 17 des Schaltungsträgers 6 im Bereich dieser Leiterbahnen 9 ebenfalls breiter ausgebildet ist als im Bereich der dritten Leiterbahn 9. Durch diese flachen Bereiche ergeben sich vorteilhafte Abschnitte des Schaltungsträgers 6 mit einem nahezu Stadion-förmigen Querschnitt, in welchen optional elektrische/elektronische Bauteile 18 oder passive Bauteile 19 optional angeordnet werden können. Gemäß dem vorliegenden Ausführungsbeispiel handelt es sich bei dem Bauteil 18 um ein SMD-Bauteil, und bei dem Bauteil 19 um eine elektronische Dickschichtstruktur.

Die Leiterbahnen 9 weisen vorzugsweise eine Dicke von weniger als 50µm auf. Sollen Bereiche geschaffen werden, in welchen die mechanischen Eigenschaften solch dünner Leiterbahnen 9 nicht ausreichend sind, so kann durch SMD-Technologie zusätzliche Versteifungselemente 20 auf der der Innenseite 15 der Stifthülse 2 zugewandten Seitenfläche 14 des Schaltungsträgers 6 aufgebracht werden, wie in dem vorliegenden Ausführungsbeispiel von Figur 5 gezeigt.

Figur 5A zeigt dazu einen Querschnitt durch ein weiteres Ausführungsbeispiel des Federkontaktstifts 1 und Figur 5B eine Längsschnittdarstellung.

Hierbei ist vorgesehen, dass eine Vielzahl der Bauteile 20 zur Versteifung in Längserstreckung des Schaltungsträgers 6 beziehungsweise der Stifthülse 2 an dem Schaltungsträger 6 angeordnet sind. Durch diese Versteifungsbauteile 20 wird ein erhöhter Druck auf die insbesondere dann starren Abschnitte 17 des Schaltungsträgers 6 ausgeübt. Ein solcher Druck ist beispielsweise bei der Verwendung eines Schleiferkontakts von Vorteil, der später näher erörtert wird. Weiterhin können dadurch große ebene Flächen beziehungsweise starre Abschnitte erzielt werden, welche durch größere Bauteile einen größeren Abstand zum Mantel der Stifthülse 2 erhalten, wie in Figur 5A gezeigt. Die Versteifungsbauteile 20 können ebenfalls durch herkömmliche Bestückungs- beziehungsweise Beschichtungstechnologien auf den Schaltungsträger in seiner Ausgangsform aufgebracht werden.

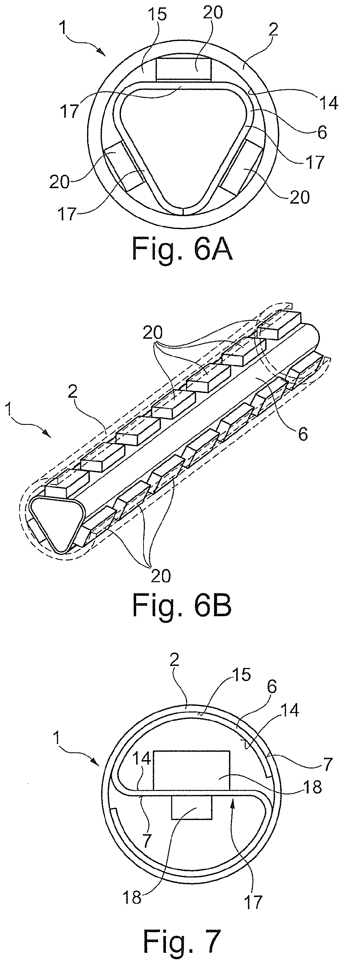

Figur 6 zeigt ein weiteres Ausführungsbeispiel des Federkontaktstifts 1 mit einer weiteren Ausführungsform des Schaltungsträgers 6. Während die Stifthülse 2 gleichbleibend ausgebildet ist, lassen sich durch den Schaltungsträger 6 unterschiedliche Formen und Funktionen realisieren. So ist gemäß dem Ausführungsbeispiel von Figur 6 vorgesehen, dass der Schaltungsträger 6 nicht, wie in dem vorhergehenden Ausführungsbeispiel einen stadionförmigen Querschnitt aufweist, sondern einen im Wesentlichen dreieckförmigen Querschnitt. Dies wird dadurch erreicht, dass drei Reihen von Versteifungsbauteilen 20 an der der Innenseite 15 zugewandten Seitenfläche des Schaltungsträgers 6 angeordnet sind. Figur 6A zeigt dazu den Federkontaktstift 1 in einer Querschnittsdarstellung, während Figur 6B den Schaltungsträger in einer perspektivischen Teildarstellung zeigt. Der Schaltungsträger 6 erhält somit einen nicht-symmetrischen Aufbau mit drei flachen beziehungsweise starren Abschnitten 17, wobei der Schaltungsträger 6 wie zuvor beim Einschieben in die Stifthülse 2 in die gezeigte Form gerollt beziehungsweise gefaltet wird, durch Verformen der verbleibenden flexiblen Bereiche. Die Reihen von Versteifungselementen 20 erstrecken sich in Längserstreckung des Schaltungsträgers 6 beziehungsweise der Stifthülse 2, sodass sich der im Wesentlichen dreiecksförmige Querschnitt ergibt.

Figur 7 zeigt in einer weiteren Querschnittsdarstellung durch den Federkontaktstift 1 ein weiteren Ausführungsbeispiel, bei welchem der Schaltungsträger 6 mit wenigstens zwei elektrischen/elektronischen Bauteilen 18 versehen ist, die an einer gegenüberliegend auf den voneinander abgewandten Seitenflächen 14 beziehungsweise 7 des Schaltungsträgers 6 angeordnet sind. Dabei sind die Bauteile 18 im Querschnitt gesehen mittig auf dem Schaltungsträger 6 in dessen Ausgangsform angeordnet. Beim Einschieben in die Stifthülse 2 wird der Schaltungsträger 6 S-förmig eingerollt beziehungsweise gefaltet, sodass sich ein starrer Abschnitt 17 des Schaltungsträgers 6 mit den Bauteilen 18 als Quersteg ergibt, der sich mittig beziehungsweise zentriert in der Stifthülse 2, im Querschnitt gesehen, erstreckt. Damit sind die Bauteile 18 besonders weit weg von der Stifthülse 2 selbst angeordnet und durch den insbesondere aus Kunststoff gefertigten Schaltungsträger 6, der sich aufgrund der S-Form über die Bauteile 18 hinweg erstreckt, sicher vor einem elektrischen Kontakt mit der Stifthülse 2 geschützt. Hierdurch ist beispielsweise eine im Querschnitt gesehen mittige Anordnung eines oder mehrerer elektrischer/elektronischer Bauteile 18 möglich.

Für die Herstellung und Bestückung des Schaltungsträgers 6 ist insbesondere vorgesehen, dass dieser in einem Nutzen, bestehend aus einer Vielzahl von einzelnen Schaltungsträgern 6, hergestellt wird. Die Bestückung der Schaltungsträger 6, beispielsweise mit elektrischen/elektronischen SMD-Bauteilen 18, beziehungsweise ein Bedrucken des Schaltungsträgers 6 mittels beispielsweise Dickschicht-Technologien, kann dabei kostengünstig auf das komplette Nutzen angewendet werden. Eine Nutzentrennung kann dabei durch Strukturen erreicht werden, welche bereits bei der Herstellung des Nutzens beziehungsweise der Platine eingebracht werden, wie beispielsweise lasergeschnittene Perforierungen. Auch ist es denkbar, ein nachträgliches Trennen des Nutzens durch Herausschneiden oder Herausstanzen einzelner Schaltungsträger beziehungsweise Platinen, beispielsweise auch aus Hilfstrukturen mit einem nachgeschalteten Trenn-Prozess, durchzuführen.

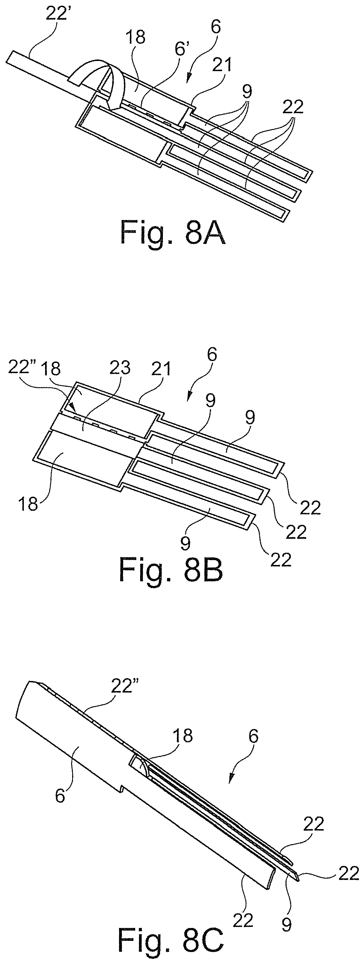

Durch eine gezielte Materialschwächung des jeweiligen Schaltungsträgers 6 an den Abschnitten beziehungsweise Bereichen, welche später, insbesondere beim Einschieben in die Stifthülse, elastisch oder biegeschlaff verformt werden sollen, kann dem Schaltungsträger 6 mindestens eine Vorzugsbiegerichtung vorgegeben werden, welche das Einbringen in den runden Bauraum der Stifthülse 2 erleichtert und die steifen beziehungsweise starren Abschnitte 17 des Schaltungsträgers 6 vor einer Überdehnung oder zu hohen Verformungen entlastet. Denkbar ist es auch, Biegungen beziehungsweise Faltungen des Schaltungsträgers 6 vorzusehen, die nicht parallel zur Längsachse des Schaltungsträgers 6 beziehungsweise der Stifthülse 2 liegen. So kann der jeweilige Schaltungsträger 6 in seiner plattenförmigen Ausgangsform mit einer entsprechenden Außenkontur und definierten Freischnitten in eine komplexere dreidimensionale Struktur geführt werden, indem dieser vor oder während des Einbaus in die Stifthülse 2 gefaltet wird. Dies soll anhand des folgenden Beispiels der Figur 8 näher erörtert werden.

Figur 8 zeigt das schrittweise Verformen einer weiteren beispielhaften Ausführungsform des Schaltungsträgers 6, der in Figur 8 allein beziehungsweise ohne Stifthülse 2 dargestellt ist.

In einer plattenförmigen Ausgangsform weist der Schaltungsträger 6 einen rechteckförmigen Trägerabschnitt 21 auf, von dem mehrere streifenförmige Kontaktabschnitte 22 parallel zueinander ausgehen. Von dem Trägerabschnitt 21 erstrecken sich Leiterbahnen 9 bis in die Kontaktabschnitte 22. Im Bereich des Trägerabschnitts 21 sind vorliegend auf den Leiterbahnen 9 zwei elektronische/elektrische Bauteile 18 angeordnet und elektrisch mit diesen kontaktiert. Dabei sind die Leiterbahnen 9 derart parallel zueinander verlaufend ausgebildet und die Bauteile 18 derart angeordnet, dass die mittlere Leiterbahn 9 nicht von einem der Bauteile 18 bedeckt ist und insoweit frei zugängig ist. Um beim Verformen einen Kurzschluss durch eine elektrische Kontaktierung mit der mittleren Leiterbahn 9 zu vermeiden, kann diese mit einer elektrisch isolierenden Schicht bedeckt werden. Gemäß dem vorliegenden Ausführungsbeispiel ist jedoch alternativ vorgesehen, dass von dem Trägerabschnitt 21 ein weiterer streifenförmiger Abschnitt 22' ausgeht, der sich in die von den Kontaktabschnitten 22 entgegengesetzte Richtung von dem Trägerabschnitt 21 auf Höhe der mittleren Leiterbahn 9 erstreckt. Die Länge des Abschnitts 22' entspricht insbesondere der Länge des Trägerabschnitts 21. Im Übergang von dem Trägerabschnitt 21 zu dem Abschnitt 22' ist vorzugsweise eine Materialschwächung vorgesehen, welche ein Umklappen des Abschnitts 22' auf den Trägerabschnitt 21 erlaubt, wie durch einen Pfeil in Figur 8A gezeigt.

Figur 8B zeigt den Schaltungsträger 6 nachdem der Abschnitt 22' auf den Trägerabschnitt 21 abgelegt wurde. Dabei überdeckt der Abschnitt 22' die mittlere Leiterbahn 9 im Bereich des Trägerabschnitts 21. Damit bildet der Abschnitt 22' einen Isolationskörper zur elektrischen Isolierung der mittleren Leiterbahn 9 in Bezug auf die Bauteile 18, sodass diese beim anschließenden Verformen des Schaltungsträgers 6 in die Zielform, wie sie in Figur 8C gezeigt ist, nicht im elektrischen Kontakt mit der mittleren Leiterbahn 9 treten können.

Figur 8C zeigt die Zielform des Schaltungsträgers 6, wie sie in der Stifthülse 2 im montierten Zustand vorliegen soll. Dabei ist der Schaltungsträger 6 um eine Längsbiegeachse (gestrichelt dargestellt) gefaltet worden, welche durch eine Perforierung 22" entlang der Biegeachse im Bereich des Trägerabschnitts 21 zwischen zwei der benachbarten Leiterbahnen 9 beziehungsweise Kontaktabschnitt 22 vorgegeben wird. Auch hier kann das Verformen beziehungsweise Falten des Schaltungsträgers 6 dadurch erreicht werden, dass dieser beim Einführen durch die Einführschrägen 11, 12 in die entsprechende Form automatisch gedrängt wird.

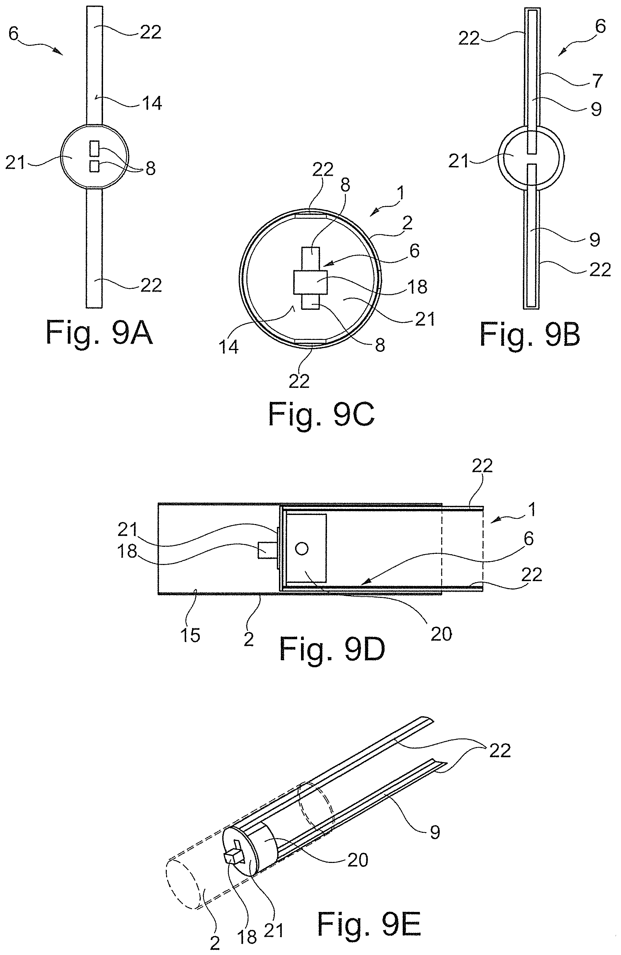

Figur 9 zeigt ein weiteres Ausführungsbeispiel des Federkontaktstifts 1, bei welchem der Trägerabschnitt 21 nunmehr kreisförmig ausgebildet ist und im verbauten Zustand senkrecht zur Längsachse der Stifthülse 2 beziehungsweise des Federkontaktstifts 1 steht. Figur 9A zeigt dazu eine Draufsicht auf den Schaltungsträger 6, der zusätzlich zu dem kreisförmigen Trägerabschnitt 21 zwei der streifenförmigen Kontaktabschnitte 22 aufweist, die gemäß diesem Ausführungsbeispiel auf einander diametral gegenüberliegenden Seiten des Trägerabschnitts 21 angeordnet sind. Während Figur 9A eine Draufsicht auf die Seitenfläche 14 zeigt, welche später zunächst abschnittsweise der Innenseite 15 der Stifthülse 2 zugewandt ist, zeigt Figur 9B eine Draufsicht auf die Seitenfläche 7, auf welcher zwei Leiterbahnen 9 ausgebildet sind, die sich jeweils von dem Trägerabschnitt 21 in die Kontaktabschnitte 22 erstrecken. Im Trägerabschnitt 21 sind die Leiterbahnen 9 durch zwei Durchkontaktierungen mit zwei Kontaktflächen 8 auf der Seitenfläche 14 elektrisch verbunden. Auf den Kontaktflächen 8 ist bevorzugt ein elektrisches/elektronisches Bauteil 18 angeordnet, wie in Figur 9C gezeigt.

Figur 9C zeigt außerdem einen Querschnitt durch den Federkontaktstift 1, der zeigt, dass der Trägerabschnitt 21 einen Außendurchmesser aufweist, der nur geringfügig kleiner ausgebildet ist als der Innendurchmesser D₂ der Stifthülse 2, sodass der Trägerabschnitt 21 senkrecht in der Stifthülse 2 anordenbar ist, wie in Figur 9C gezeigt.

Figur 9D zeigt eine Längsschnittdarstellung durch die Stifthülse 2 des Federkontaktstifts 1, aus welcher ersichtlich ist, dass die Kontaktfläche 22 zumindest im Wesentlichen in einem rechten Winkel zu dem Trägerabschnitt 21 in der Stifthülse 2 nach der Montage liegen und sich parallel zur Innenseite 15 der Stifthülse 2 erstrecken. Dabei sind beide Kontaktabschnitte 22 in die gleiche Richtung gebogen, sodass sie in der Stifthülse 2 einander gegenüberliegen, wobei die Leiterbahnen 9 aufgrund des gefalteten Schalterträgers 6 einander zugewandt sind. Bevorzugt ist auf der dem Bauteil 18 abgewandten Seite des Trägerabschnitts 21 ein im Vergleich zum Bauteil 18 größeres Versteifungsbauteil 20 angeordnet, das selbstverständlich ebenfalls elektrisch oder elektronisch ausgebildet sein kann. Hierdurch wird sichergestellt, dass der Trägerabschnitt 21 seine Form beibehält, insbesondere um beispielsweise auch axiale Kräfte, wie beispielsweise eines axial wirkenden Federelements, wie beispielsweise des Federelements 5, aufnehmen zu können. Der Schaltungsträger 6 ist hierbei bevorzugt im Kraftfluss zwischen dem Federelement 5 und der Stifthülse 2 integriert und stützt sich dazu axial an der Stifthülse 2 entgegen der Federkraft ab.

Zweckmäßigerweise weist das Bauteil 20 beidseitig jeweils eine Abflachung und Aufhängung auf, entlang welcher die Kontaktabschnitte 22 an dem Bauteil 20 vorbeigeführt werden, wie insbesondere in Figur 9D gezeigt.

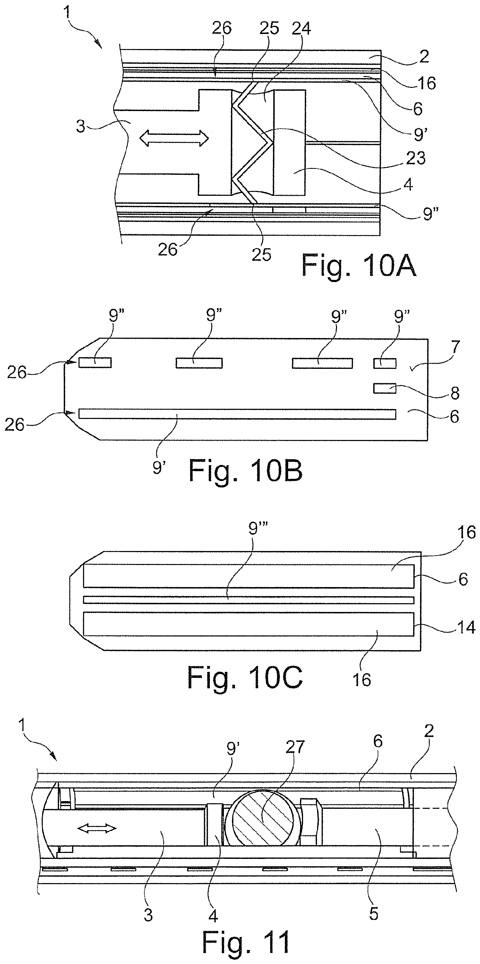

Gemäß einem weiteren Ausführungsbeispiel, das in Figur 10 gezeigt ist, ist vorgesehen, dass der Federkontaktstift 1 als Schaltkontaktstift ausgebildet ist. Dazu ist in dem Führungsende 4 des Prüfkopfs 3 oder in einen mit dem Führungsende 4 mechanisch gekoppelten Halteelement ein elektrisch leitfähiges Kontaktelement 23 angeordnet. Vorliegend ist das Kontaktelement 23 als Federelement ausgebildet, dessen Federkraft senkrecht zur Schieberichtung des Prüfkopfs 3 wirkt und in einer radialen Durchgangsöffnung, insbesondere Durchgangsbohrung oder Querbohrung 24, durch das Führungsende 4 erstreckt. Dabei steht das Kontaktelement 23 über das Führungsende 4 radial vor, sodass es mit seinen endseitigen Kontaktflächen 25 radial gegen die Innenseite 15 der Stifthülse 2 oder des Schaltungsträgers 6 vorgespannt ist.

Figuren 10B und 10A zeigen hierzu eine Draufsicht auf die Seitenfläche 7 (Figur 10B) und die Seitenfläche 14 (Figur 10C) des Schaltungsträgers 6 dieses Federkontaktstifts 1. Der Schaltungsträger 6 weist auf der Seitenfläche 7 eine durchgehende Leiterbahn 9' sowie eine unterbrochene Leiterbahn 9" auf, die sich in Längserstreckung des Schaltungsträgers 6 erstrecken und jeweils eine Kontaktbahn 26 bilden. Zur bestehenden Leiterbahn 9' und 9" ist außerdem eine Kontaktfläche 8 angeordnet. Auf der Rückseite beziehungsweise der Seitenfläche 14 des Schaltungsträgers 6 sind die Leiterbahnen 9', 9" mit einer elektrischen Isolierung versehen, und eine weitere elektrische Leiterbahn 9'" zwischen den Leiterbahnen 9' und 9" verlaufend ausgebildet, wobei die Leiterbahn 9''' mit der Kontaktfläche 8 durch eine Durchkontaktierung elektrisch verbunden ist.

Die Schaltfunktion des Federkontaktstifts 1 erfolgt somit nunmehr zwischen den Kontaktbahnen 26. Im eingerollten Zustand befinden sich diese einander gegenüberliegend, wie in Figur 10A gezeigt. Das Führungsende 4 ist dazu ausgebildet, in den eingerollten Schaltungsträger 6 eingeschoben zu werden, sodass das Kontaktelement 23 radial gegen den Schaltungsträger 6, insbesondere dessen Seitenfläche 7 vorgespannt ist. Wird nun der Prüfkopf aufgrund einer Berührungskontaktierung eines Prüflings axial verlagert, wie durch einen Doppelpfeil in Figur 10A gezeigt, so wird das Kontaktelement 23 entlang der Kontaktbahn 26 bewegt. Weil die Leiterbahn 9" unterbrochen ausgebildet ist, wird eine Schaltfunktion realisiert und ein Stromkreis geschlossen, sobald das Kontaktelement 23 die Leiterbahn 9' und 9" elektrisch miteinander verbindet. Die unterbrochenen Bereiche der Leiterbahn 9" sind auf der Rückseite mit einer gemeinsamen Leiterbahn verbunden. Die mittlere Leiterbahn 9", durch welche ein elektrischer Kontakt zur Stifthülse 2 und damit zum Prüfkopf erzeugt wird, ist optional. Das Kontaktelement 23 besteht insbesondere aus einem guten elektrischen Leiter. In Abhängigkeit von der Schiebestellung des Prüfkopfs 3 ist somit die Leiterbahn 9' und 9" elektrisch miteinander verbunden oder voneinander getrennt. Hierdurch ist auf einfache Art und Weise eine Schaltkontaktfunktion des Federkontaktstifts 1 realisiert.

Bewegt sich das Kontaktelement 23 somit in einen Bereich, in welchem die Leiterbahn 9' und 9" miteinander elektrisch verbunden sind, ist der Schalter eingeschaltet beziehungsweise geschlossen. Bewegt sich der Schalter in einen Bereich, in welchem das Kontaktelement einerseits an der Leiterbahn 9' anliegt und andererseits den aus Kunststoff gefertigten Schaltungsträger 6 im unterbrochenen Abschnitt der Leiterbahn 9" kontaktiert, ist ein elektrischer Kontakt unterbrochen und der Schalter damit ausgeschaltet.

Figur 11 zeigt ein alternatives Ausführungsbeispiel des Federkontaktstifts 1 als Schaltkontaktstift, bei welchem anstelle eines Federelements als Kontaktelement 23 ein Kugelschleifer 27 zwischen dem Prüfkopf 3 und dem Federelement 5 verspannt gehalten ist. Hier wird eine Eigenelastizität des Schaltungsträgers 6 ausgenutzt, um über Rückstellkräfte der Kontaktabschnitte 22 einen dauerhaften Berührungskontakt zwischen Kugelschleifer 27 und Schaltungsträger 6 zu gewährleisten. Der Berührungskontakt des Kontaktelements 23 kann somit ein starres Bauteil sein, wie beispielsweise der in Figur 11 gezeigte Kugelschleifer 27. Zweckmäßigerweise lässt der Bauraum in der Stifthülse 2 dabei ein radiales Spiel für die Kontaktabschnitte 22 des Schaltungsträgers 6 zu.

Durch den Einsatz des starren Schleifkörpers beziehungsweise Kontaktelements 23 kann der Aufbau insgesamt vereinfacht werden. Vorzugsweise werden die Kontaktbahnen 26 beziehungsweise die Leiterbahnen 9' und 9" für die verbleibende Berührungskontaktierung beschichtet, um ihre Lebensdauer zu erhöhen und den Verschleiß zu vermindern. Neben unterschiedlichen galvanischen Verfahren bieten sich dabei auch mittels Dickschichttechnologie aufgebrachte Beschichtungen, beispielsweise auf Kohlenstoffbasis, an.

Alternativ zur Ausbildung als Schaltkontaktstift ist der Federkontaktstift 1 gemäß einem weiteren Ausführungsbeispiel als Federwegmesssensor beziehungsweise linearer Potentiometer ausgebildet. Dies ermöglicht neben der elektrischen Kontaktierung des Prüflings eine Aussage über die Höhe beziehungsweise die richtige Montage des Prüflings. Mögliche Anwendungen sind hier beispielsweise das Vermessen von Pin-Längen in Steckern, Tiefen von Sacklochbohrungen, die Anwesenheit von Bauteilen sowie deren Höhe. Um dies erfassen zu können, ist ein weiteres elektrisches Signal notwendig, welches einen Rückschluss auf die Verlagerung des Prüfkopfs 3 zulässt. Eine mögliche Lösung hierfür ist die Verwendung eines variablen elektrischen Widerstands, welcher sich entsprechend der Einpresstiefe des Federkontaktstifts verändert. Diese Lösung ist grundsätzlich Stand der Technik und wird auch als Potentiometer bezeichnet.

Ein wesentlicher Bestandteil eines derartigen Potentiometers ist die Ausbildung zumindest einer der Kontaktbahnen 26 als elektrische Widerstandsbahn 28, welche in Kontakt mit dem Kontaktelement 23 steht. Die Bewegung des Kontaktelements 23 beziehungsweise Schleifens wird durch die Bewegung des Prüfkopfs 3 bedingt. Durch die Position des Kontaktelements 23 auf der Widerstandsbahn 28, die sich entlang der Längserstreckung des Schaltungsträgers 6 erstreckt, stellt sich nun ein spezifischer elektrischer Widerstandswert ein, welcher als elektrische Größe gemessen wird. Die Messung erfolgt möglichst als Spannungssignal. Hierzu wird bevorzugt eine konstante elektrische Spannung an der Widerstandsbahn 28 angelegt, welche von dem Kontaktelement 23 positionsabhängig abgegriffen wird. Die Widerstandsbahn wird dazu durch zwei Elektroden elektrisch kontaktiert. Prinzipiell ist bevorzugt, dass sich die Widerstandsbahn 28 durch einen elektrischen Widerstandswert auszeichnet, welcher wesentlich höher ist als der der Elektroden, sodass sich eine positionsabhängige Kennlinie ergibt. Alternativ kann elektrischer Widerstand, welcher sich zwischen dem Schleifkontakt und einer Widerstandsbahn 28 einstellt, gemessen werden. Vorteil hierbei ist, dass nur zwei Leiter für die Messung notwendig sind. Nachteil ist, dass der Einfluss von zusätzlichen elektrischen Widerständen, beispielsweise durch Kabelverbindungen, Schleifkontakt auf Widerstandsbahn und dergleichen das Messergebnis verfälschen können.

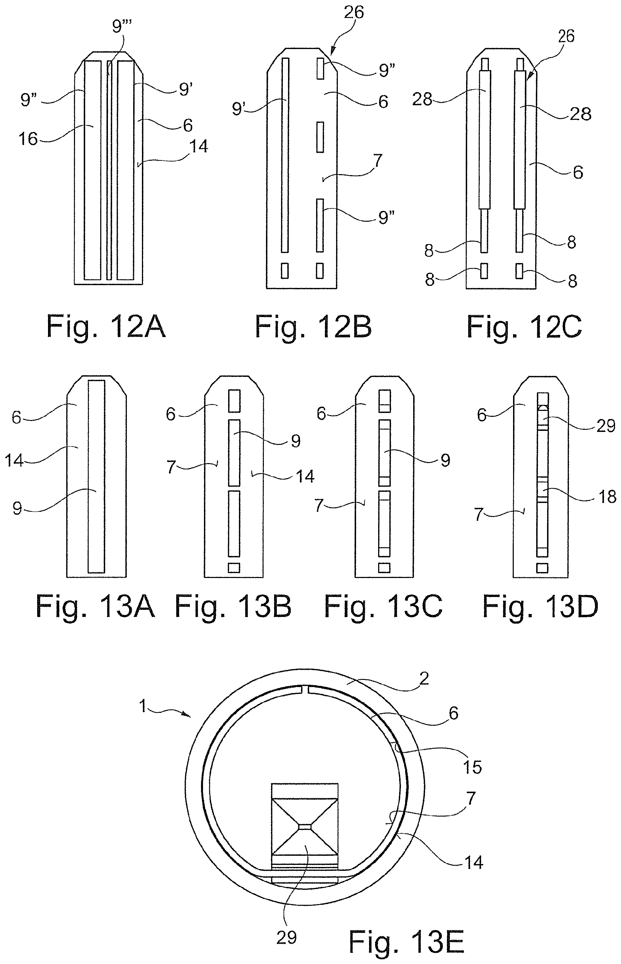

Figur 12 zeigt in einem Ausführungsbeispiel einen Leiter für den Schaltungsträger 6 als Linearpotentiometer. Figur 12A zeigt dazu die Rückseite beziehungsweise die dem der Innenseite 15 zugewandte Seitenfläche 14 des Schaltungsträgers 6 in einer Draufsicht. Auf dem Schaltungsträger 6 sind wie im vorhergehenden Ausführungsbeispiel drei parallel zueinander verlaufende Leiterbahnen 9 angeordnet, wobei die zwei außen verlaufenden Leiterbahnen 9' und 9" durch eine elektrische Isolierung 16 beschichtet sind, und die mittlere Leiterbahn 9''' freiliegt, um in montiertem Zustand im elektrischen Berührungskontakt mit der Stifthülse 2 zu stehen.

Figuren 12B und 12C zeigen eine Draufsicht auf die Seitenfläche 7 des Schaltungsträgers 6. Die außenliegenden Leiterbahnen 9 durchdringen dabei die Seitenfläche 7, sodass sich - wie in Figur 10B gezeigt - eine durchgehende Leiterbahn 9' und eine unterbrochene Leiterbahn 9" ergibt, wobei die Leiterbahn 9" einfach unterbrochen ist. Der unterbrochene Abschnitt wird durch eine Widerstandsbahn 28 überbrückt, wobei auch die Leiterbahn 9' mit einer Widerstandsbahn 28 versehen ist. Eine der Widerstandsbahnen 28 zeichnet sich durch einen, im Unterschied zu üblichen Leiterbahnen, wesentlich höheren höherliegenden spezifischen elektrischen Widerstand aus. Im Ausführungsbeispiel von Figur 12C ist dies durch sogenannte Dichtschichtwiderstände realisiert. Derartige Widerstände werden beispielsweise mittels Siebdruckverfahren auf den Schaltungsträger 6 aufgebracht und in einem anschließenden Sinter- oder Einbrennvorgang ausgehärtet. Alternativ zu einem Sinter-Einbrenn-Vorgang ist auch ein Trocknungsvorgang oder eine chemische Reaktion denkbar, durch welche ein flüssiges/pastöses Medium solcher Dickschichten aushärtet. Bekannt ist es, derartige Widerstandsstrukturen aus Kunststoff/Polymer-Composite aufgebaut, um die entsprechend hohen elektrischen Widerstände realisieren zu können.

Vorliegend ist einer dieser Widerstandsbahnen 28 auf die durchgängige Leiterbahn 9' aufgebracht, welche elektrisch mit einer der Kontaktflächen 8 verbunden ist. Diese Widerstandsbahn 28 wird vorliegend als Kollektorbahn bezeichnet. An der damit elektrisch verbundenen Kontaktfläche 8 wird das wegabhängige Signal abgegriffen. Der aufgebrachte Dickschichtwiderstand auf der Kollektorbahn ist optional und hat keine elektrische Funktion, sondern dient dazu, den Verschleiß des Schleifers beziehungsweise des Kontaktelements 23 zu minimieren. Die eigentliche Widerstandsbahn 28 beziehungsweise Kontaktbahn 26 wird zwischen den zwei metallischen Leiterbahnabschnitten der Leiterbahn 9" aufgebracht, welche mit zwei unterschiedlichen Kontaktflächen 8 in Verbindung stehen. Der elektrische Widerstand, welcher sich zwischen den beiden Kontaktflächen 8, die der Widerstandsbahn 28 auf der Leiterbahn 9" zugeordnet sind, ergibt/einstellt, lässt sich durch die geometrische Form der Widerstandsbahn 28, insbesondere Dicke, Breite und Länge sowie deren elektrischen Eigenschaften, insbesondere spezifische Leitfähigkeit, der aufgebrachten Widerstandspaste einstellen. Prinzipiell ist der elektrische Widerstand so zu wählen, als der elektrische Widerstand der Leitungen zu diesem Widerstand, beispielsweise größer 5 kΩ. Wird die Kollektorbahn nun mit der Widerstandsbahn durch ein Kontaktelement, beispielsweise wie in Figur 10A gezeigt, kontaktiert, so lässt sich ein Messsignal bestimmen, aus welchem sich die Einpresstiefe des Prüfkopfs 3 in die Stifthülse 2 bestimmen lässt.

Figur 13 zeigt ein weiteres Ausführungsbeispiel des Federkontaktstifts 1, bei welchem als elektrisches/elektronisches Bauteil ein optisches Bauteil 29, insbesondere ein Leuchtmittel oder ein Opto-elektronisches Bauteil, eingesetzt ist. Durch die Integration von Opto-elektronischen Bauteilen kann mithilfe der Technologie eine sinnvolle Schnittstelle zu Lichtwellenleitern sowohl als Empfänger mithilfe einer Fotodiode oder als Sender mithilfe einer Lichtquelle, beispielsweise einer Leuchtdiode, realisiert werden. Die primäre Funktion des Federkontaktstifts 1 ist dann die in der Kontaktierung des zu prüfenden Lichtwellenleiters als Prüfling auch die Wandlung des Lichtsignals in ein elektrisches Signal beziehungsweise eines elektrischen Impulses in ein optisches Signal (Sender).

Figuren 13A, 13B, 13C und 13D zeigen dazu den beispielhaften schrittweisen Aufbau des Schaltungsträgers 6. Figur 13A zeigt eine Draufsicht auf die Rückseite beziehungsweise auf die Seitenfläche 7 des Schaltungsträgers 6, mit einer durchgehend elektrisch isolierten Leiterbahn 9. Figuren 13B bis 13D zeigen eine Draufsicht auf die Vorderseite beziehungsweis die Seitenfläche 14. Die Leiterbahn 9 ist unterbrochen ausgebildet, wie insbesondere in Figur 13B gezeigt. Im darauffolgenden Fertigungsschritt werden die freien Leiterbahnenden verzinnt. Abschließend, wie in Figur 13D gezeigt, werden auf die verzinnten Abschnitte, die Unterbrechungen überbrücken, elektrische/elektronische Bauteile 18 und 29 aufgebracht und elektrisch kontaktiert. Bei dem Bauteil 18 handelt es sich beispielsweise um einen elektrischen Widerstand beziehungsweise Passiv-SMD-Komponente, und bei dem Bauteil 29, wie zuvor bereits erwähnt, um ein optisches Bauteil, insbesondere um einen Opto-elektronischen Wandler.

Beim Einsetzen in die Stifthülse 2, wie in Figur 13E beispielhaft gezeigt, wird der Schaltungsträger 6 wie zuvor bereits beschrieben eingerollt, sodass das Bauteil 29 im inneren der Stifthülse 2 liegt.

Neben der Übermittlung von Daten mittels eines optischen Signals, kann dieser Aufbau mit einer Lichtquelle als Bauteil 29 auch dazu genutzt werden, ein optisches Signal zu einem Menschen/Benutzer zu senden. Ein derartiges Signal ist beispielsweise sinnvoll bei einer manuellen Montage, in welcher direkt nach der Montage eine elektrische Prüfung durchgeführt wird. Neben elektronischen Bauteilen 18, 29 können zudem auch optische Bauteile, wie Linsen, auf dem Schaltungsträger 6 vor der Montage in der Stifthülse 2 aufgebracht werden. Prinzipiell ist es auch hier zweckmäßig, solche Komponenten auf dem Schaltungsträger 6 aufzubringen, wenn diese sich noch im Nutzen befinden. Auch ist es denkbar, einen ähnlichen Prozess bei der Bestückung wie bei SMD-Bauteilen durchzuführen, wobei in diesem Fall anstatt von Lötzinn Kleber verwendet wird. Für das Aufbringen von Klebstoff können wiederum bereits bekannte Technologien auf der Leiterplattenherstellung verwendet werden. Neben optisch funktionalen Bauteilen kann es auch sinnvoll sein, weitere elektronische Bauteile mit auf der Platine anzubringen. Zum Beispiel ist es vorteilhaft, für eine LED-Lichtquelle einen in Serie geschalteten elektrischen Widerstand, wie in Figur 13B vorgeschlagen, vorzusehen. Hierdurch ergibt sich der Vorteil, dass der Federkontaktstift auch bei einer elektrischen Energieversorgung von geringerer Qualität, ein verlässliches Messergebnis in Bezug auf Genauigkeit und Konstanz gewährleistet. Passive Elektronikbauteile für einen Empfänger, bestehend aus einer Fotodiode, können beispielsweise Kondensatoren sowie elektrische Widerstände sein, welche in Serie oder parallel zu dem jeweiligen Sensor auf dem Schaltungsträger 6 verschaltet sind, um beispielsweise einen elektrischen Filter gegen störende Einflüsse auf das Signal zu realisieren.

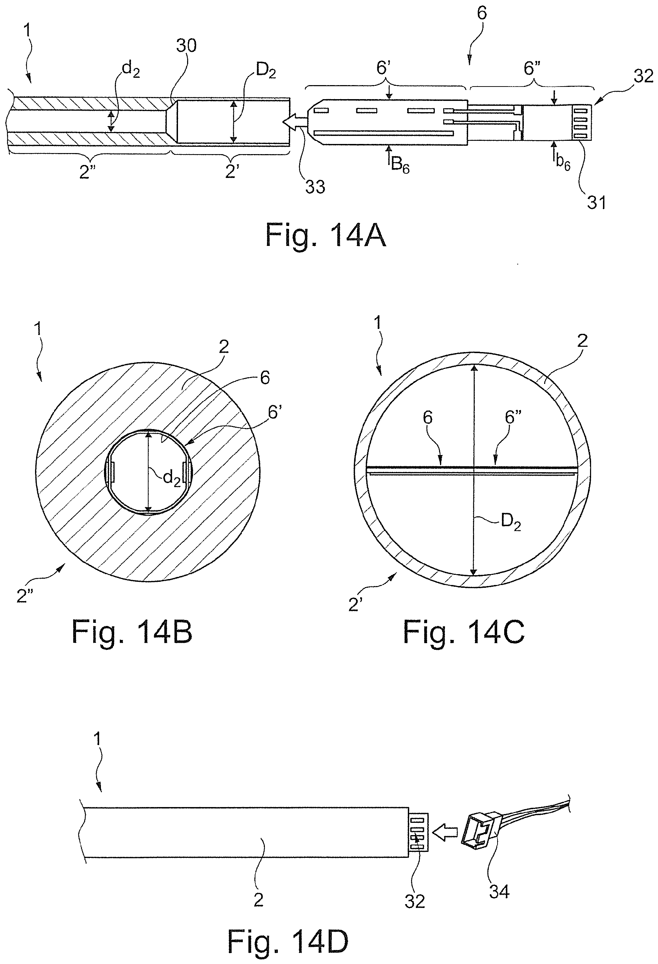

Figur 14 zeigt ein weiteres Ausführungsbeispiel des Federkontaktstifts 1, das sich von den vorhergehenden Ausführungsbeispielen dadurch unterscheidet, dass die Stifthülse 2 einen ersten Abschnitt 2' mit dem Innendurchmesser D₂ und einen sich daran axial anschließenden zweiten Abschnitt 2" mit einem kleineren Innendurchmesser d₂ anschließt. Im Übergang von dem ersten Abschnitt 2' zu dem zweiten Abschnitt 2" ist eine keilförmige oder kegelförmige Einführschräge 30 ausgebildet.

Der Schaltungsträger 6 weist ebenfalls zwei Abschnitte 6' und 6" auf, wobei der Schaltungsträger 6 in dem ersten Abschnitt 6' die Breite B₆ und in dem zweiten Abschnitt 6" eine Breite b₆ aufweist, die kleiner ist als die Breite B₆ in dem ersten Abschnitt 6'. In dem ersten Abschnitt 6' ist der Schaltungsträger 6 gemäß dem Ausführungsbeispiel von Figur 10B ausgebildet. In dem zweiten Abschnitt 6" bildet der Schaltungsträger 6 einen streifenförmigen Kontaktabschnitt mit mehreren Leiterbahnen 9 auf, der an seinem freien Ende einen Anschlussstecker 32 bildet.

Der Abschnitt 6" zeichnet sich durch eine hohe Steifigkeit aus, während der Abschnitt 6' eine hohe Flexibilität aufweist. Dem Abschnitt 6' zugewandten Endbereich des Abschnitts 6" ist der Abschnitt 6" ebenfalls flexibel verformbar gestaltet, sodass ein Übergang von einem verformten ersten Abschnitt 6' zu dem im Wesentlichen steifen zweiten Abschnitt 6" möglich ist. Zum Versteifen des Abschnitts 6' sind auch hier beispielsweise Leiterplattenstrukturen wie Metallbeschichtungen oder Lötstofflack verwendet. Zusätzlich kann einer oder mehrere der Versteifungsbauteile 20 eingesetzt und beispielsweise auf den Schaltungsträger 6 aufgeklebt werden. Die Versteifungsbauteile 20 werden bevorzugt ebenfalls in einem Nutzen hergestellt und beim Trennen der Schaltungsträger 6 ebenfalls aus ihrem Nutzen getrennt.

Wird der Schaltungsträger 6 in die Stifthülse 2 eingeführt, wie in Figur 14A durch einen Pfeil 33 gezeigt, so wird der erste Abschnitt 6' der Schaltungsträger 6 in den zweiten Abschnitt 2" der Stifthülse 2 mit dem kleineren Durchmesser d₂ eingerollt und an die Innenseite 14 der Mantelwand beziehungsweise der Stifthülse 2 angelegt. Im Abschnitt 6", der dann im Abschnitt 2' liegt, erfolgt keine Verformung des Schaltungsträgers 6, weil dieser im Abschnitt 6" eine Breite b₆ aufweist, die kleiner ist als der Innendurchmesser D₂.

Figur 14B zeigt dazu eine Querschnittsdarstellung durch den Federkontaktstift 1 im Abschnitt des zweiten Abschnitts 2" und Figur 14C eine Querschnittsdarstellung durch den Federkontaktstift 1 im Abschnitt 2'. Hierbei ist ohne weiteres zu erkennen, dass im Abschnitt 2" der Schaltungsträger 6 verformt beziehungsweise eingerollt und im Abschnitt 2' steif/starr und eben ausgebildet ist. Figur 14D zeigt die Endposition des Schaltungsträgers 6 in der Stifthülse 2 in einer Seitenansicht, wobei der Schaltungsträger 6 derart ausgebildet ist, dass der Anschlussstecker 32 von dem freien Ende der Stifthülse 2 vorsteht, sodass er durch einen Kontaktstecker 34, der auf den Anschlussstecker 32 aufgeschoben wird, elektrisch kontaktierbar ist. Der Kontaktstecker 34 ist beispielsweise als ZIF-Stecker ausgebildet, sodass eine elektrische Kontaktierung der Schalterplatte 6 lötfrei möglich ist. Optional kann der Kontaktstecker 32 durch eine oder mehrere Versteifungselemente oder Strukturen auf dem Schaltungsträger 6 im Bereich des Abschnitts 6" erhöht werden.

## Patentansprüche

1. Kontaktstift, insbesondere Federkontaktstift (1), mit einem Prüfkopf (3) zur Berührungskontaktierung einer elektrisch leitfähigen Kontaktfläche eines Prüflings, insbesondere Wafer, Leiterplatte oder dergleichen, und mit einer Stifthülse (2), in welcher der Prüfkopf (3) mit einem Führungsende (4) axial verschiebbar gelagert angeordnet ist, **gekennzeichnet durch** einen zumindest abschnittsweise flexibel verformbaren/verformten Schaltungsträger (6), auf welchem wenigstens ein elektrisches/elektronisches Bauteil (18) angeordnet ist, und der durch Rollen und/oder Falten in die Stifthülse (2) axial eingeschoben/einschiebbar ist.

2. Kontaktstift nach Anspruch 1, **dadurch gekennzeichnet, dass** der Schaltungsträger (6) zumindest abschnittsweise eine Eigenelastizität aufweist, sodass der Schaltungsträger (6) durch die Eigenelastizität in der Stifthülse (2) zumindest bereichsweise gegen eine Innenseite (15) der Stifthülse (2) vorgespannt ist.

3. Kontaktstift nach einem der vorhergehenden Ansprüche, **dadurch gekennzeichnet, dass** der Schaltungsträger (6) wenigstens eine elektrisch leitfähige Kontaktfläche (8) aufweist, die gegen die Innenseite (15) der Stifthülse (2) vorgespannt/vorspannbar ist.

4. Kontaktstift nach einem der vorhergehenden Ansprüche, **dadurch gekennzeichnet, dass** der Schaltungsträger (6) zumindest abschnittsweise starr ausgebildet ist, wobei auf einem starren Abschnitt (17) insbesondere das elektrische/elektronische Bauteil (18,20) angeordnet ist.

5. Kontaktstift nach einem der vorhergehenden Ansprüche, **dadurch gekennzeichnet, dass** zumindest ein starrer Abschnitt (17) des Schaltungsträgers (6) beabstandet zu der Innenwand (15) der Stifthülse (2) angeordnet/anordenbar ist.

6. Kontaktstift nach einem der vorhergehenden Ansprüche, **dadurch gekennzeichnet, dass** der Schaltungsträger (6) auf seiner der Innenseite (15) zugewandten Seitenfläche (14) zumindest bereichsweise eine elektrisch isolierende Schicht (16) aufweist.

7. Kontaktstift nach einem der vorhergehenden Ansprüche, **dadurch gekennzeichnet, dass** der Schaltungsträger (6) kreisringförmig, dreieckförmig oder S-förmig gerollt/rollbar und/oder gefaltet/faltbar ist.

8. Kontaktstift nach einem der vorhergehenden Ansprüche, **dadurch gekennzeichnet, dass** der Schaltungsträger (6) einen kreisförmigen, insbesondere starren Trägerabschnitt (21) für das zumindest eine Bauteil (18,20) aufweist, von dem zumindest ein streifenförmiger Kontaktabschnitt (22) ausgeht, der durch Falten des Schaltungsträgers (6) senkrecht zu dem Trägerabschnitt (21) ausgerichtet/ausrichtbar ist, um zumindest im Wesentlichen parallel zu der Längserstreckung der Stifthülse (2) in der Stifthülse (2) zu liegen, und wobei der Trägerabschnitt (21) einen Außendurchmesser aufweist, der kleiner ist als der Innendurchmesser (D₂) der Stifthülse (2).

9. Kontaktstift nach Anspruch 8, **dadurch gekennzeichnet, dass** der Kontaktabschnitt (22) auf seiner von der Innenseite (15) der Stifthülse (2) abgewandten Seitenfläche wenigstens eine elektrisch leitfähige Leiterbahn (9) aufweist.

10. Kontaktstift nach einem der vorhergehenden Ansprüche, **dadurch gekennzeichnet, dass** der Schaltungsträger (6), insbesondere der Kontaktabschnitt (22), an einem freien, insbesondere ungefalteten/ungerollten Ende eine Struktur (32) für eine Leiterplattensteckverbindung ausbildet.

11. Kontaktstift nach einem der vorhergehenden Ansprüche, **dadurch gekennzeichnet, dass** der Schaltungsträger (6) wenigstens eine erste Einführschräge (11) aufweist, durch welche ein Einrollen des Schaltungsträgers (6) beim Einschieben in die Stifthülse (2) erfolgt oder zumindest unterstützt wird.

12. Kontaktstift nach einem der vorhergehenden Ansprüche, **dadurch gekennzeichnet, dass** die Stifthülse (2) zumindest eine zweite Einführschräge (22), insbesondere Fase, an einem axial offenen Ende aufweist, durch welches der Schaltungsträger (6) in die Stifthülse (2) eingeschoben/einschiebbar ist.

13. Kontaktstift nach einem der vorhergehenden Ansprüche, **dadurch gekennzeichnet, dass** der Schaltungsträger (6) zum Bilden eines Schaltkontaktstifts oder eines Linear-Potentiometers zumindest eine in Längserstreckung der Stifthülse (2) verlaufende Kontaktbahn (26), insbesondere Widerstandsbahn (28), aufweist, die durch ein in der Stifthülse (2) durch den Prüfkopf (3) verlagerbares Kontaktelement (23) elektrisch in zumindest einer Schiebestellung des Prüfkopfs (3) zu der Stifthülse (2) kontaktierbar ist.

14. Kontaktstift nach einem der vorhergehenden Ansprüche, **dadurch gekennzeichnet, dass** das Kontaktelement (23) wenigstens ein Federelement aufweist oder bildet, das eine Kontaktfläche (25) des Kontaktelements (23) radial zur Kontaktierung der Kontaktbahn (26) vorspannt.

15. Kontaktstift nach einem der vorhergehenden Ansprüche, **dadurch gekennzeichnet, dass** das zumindest eine elektrische/elektronische Bauteil (29) als opto-elektronisches Bauteil, Leuchtmittel, Sensor und/oder elektrischer Widerstand ausgebildet ist.

## Claims

1. Contact pin, in particular a spring contact pin (1), comprising a test head (3) for contacting an electrically conductive contact surface of a test object, in particular a wafer, a printed circuit board or the like, and comprising a pin sleeve (2), in which the test head (3) is mounted with a guide end (4) in a longitudinally displaceable manner, **characterized by** a circuit carrier (6) which is at least in sections flexibly deformable/deformed, on which at least one electrical/electronic component (18) is arranged and which is or can be axially inserted into the pin sleeve (2) by rolling and/or folding.

2. Contact pin according to claim 1, **characterized in that** the circuit carrier (6) at least in sections has an inherent elasticity, so that the circuit carrier (6) is pretensioned against an inner side (15) of the pin sleeve (2) at least in certain areas by the inherent elasticity in the pin sleeve (2)

3. Contact pin according to one of the preceding claims, **characterized in that** the circuit carrier (6) has at least one electrically conductive surface (8) which is/can be pretensioned against the inner side (15) of the pin sleeve (2).

4. Contact pin according to one of the preceding claims, **characterized in that** the circuit carrier (6) is rigid at least in sections, the electrical/electronic component (18, 20) in particular being arranged on a rigid section (17).

5. Contact pin according to one of the preceding claims, **characterized in that** at least one rigid section (17) of the circuit carrier (6) is arranged/can be arranged at a distance from the inner wall (15) of the pin sleeve (2).

6. Contact pin according to one of the preceding claims, **characterized in that** the circuit carrier (6) has an electrically insulating layer (16) at least in sections on its side face (14) facing the inside (15).

7. Contact pin according to one of the preceding claims, **characterized in that** the circuit carrier (6) is rolled up/rollable and/or folded/foldable in a circular, triangular or S-shaped manner.

8. Contact pin according to one of the preceding claims, **characterized in that** the circuit carrier (6) has a circular, in particular rigid carrier section (21) for the at least one component (18, 20), from which at least one strip-shaped contact section (22) emanates, which is aligned/alignable perpendicular to the carrier portion (21) by folding the circuit carrier (6) so as to lie at least substantially parallel to the longitudinal direction of the pin sleeve (2) in the pin sleeve (2), and wherein the carrier portion (21) has an outer diameter which is smaller than the inner diameter (D2) of the pin sleeve (2).

9. Contact pin according to claim 8, **characterized in that** the contact section (22) has at least one electrically conductive conductor track (9) on its side face facing away from the inside (15) of the pin sleeve (2).

10. Contact pin according to one of the preceding claims, **characterized in that** the circuit carrier (6), in particular the contact section (22), forms a structure (32) for a printed circuit board plug-in connection at a free, in particular unfolded/unrolled end.

11. Contact pin according to one of the preceding claims, **characterized in that** the circuit carrier (6) has at least one first insertion chamfer (11), through which the circuit carrier (6) is rolled during insertion into the pin sleeve (2) or is at least supported.

12. Contact pin according to one of the preceding claims, **characterized in that** the pin sleeve (2) has at least a second insertion chamfer (22), in particular a chamfer, at an axially open end, through which the circuit carrier (6) can be inserted/is insertable into the pin sleeve (2).

13. Contact pin according to one of the preceding claims, **characterized in that** the circuit carrier (6) has at least one contact track (26), in particular a resistance track (28), extending in the longitudinal direction of the pin sleeve (2) for forming a switch contact pin or a linear potentiometer, which can be contacted electrically in at least one sliding position of the test head (3) relative to the pin sleeve (2) by a contact element (23) which can be displaced in the pin sleeve (2) by the test head (3).

14. Contact pin according to one of the preceding claims, **characterized in that** the contact element (23) has or forms at least one spring element which pretenses a contact surface (25) of the contact element (23) radially for contacting the contact track (26).

15. Contact pin according to one of the preceding claims, **characterized in that** the at least one electrical/electronic component (29) is designed as an optoelectronic component, illuminant, sensor and/or electrical resistor.

## Revendications

1. Broche de contact, en particulier broche de contact à ressort (1), avec une tête d'essai (3) pour la connexion de contact d'une surface de contact électroconductrice d'un échantillon, en particulier une plaquette, un circuit imprimé ou similaire, et avec un manchon de broche (2) dans lequel la tête d'essai (3) avec une extrémité de guidage (4) est disposé en étant monté de façon axialement coulissante, **caractérisée par** un support de circuit (6) flexiblement déformable/déformé au moins en partie, sur lequel est disposé au moins un composant électrique/électronique (18), et qui est introduit/introduisible axialement par roulement et/ou par pliage dans le manchon de broche (2).

2. Broche de contact selon la revendication 1, **caractérisée en ce que** le support de circuit (6) présente une propre élasticité au moins en partie de façon à ce que le support de circuit (6) soit précontraint par sa propre élasticité dans le manchon de broche (2) au moins en partie contre une face intérieure (15) du manchon de broche (2).

3. Broche de contact selon l'une des revendications précédentes, **caractérisée en ce que** le support de circuit (6) présente au moins une surface de contact électroconductrice (8) qui est précontrainte/peut être précontrainte contre la face intérieure (15) du manchon de broche (2).

4. Broche de contact selon l'une des revendications précédentes, **caractérisée en ce que** le support de circuit (6) est, au moins en partie, conçu de manière rigide, le composant électrique/électronique (18, 20) étant en particulier disposé sur une section rigide (17).

5. Broche de contact selon l'une des revendications précédentes, **caractérisée en ce qu'**au moins une section rigide (17) du support de circuit (6) est disposé/peut être disposée à distance de la paroi intérieure (15) du manchon de broche (2).

6. Broche de contact selon l'une des revendications précédentes, **caractérisée en ce que** le support de circuit (6) présente, sur sa face latérale (14) tournée vers la face intérieure (15), au moins en partie une couche électriquement isolante (16).

7. Broche de contact selon l'une des revendications précédentes, **caractérisée en ce que** le support de circuit (6) est roulé/peut être roulé et/ou est plié/peut être plié en forme circulaire, triangulaire ou en S.

8. Broche de contact selon l'une des revendications précédentes, **caractérisée en ce que** le support de circuit (6) présente une section de support (21) circulaire, en particulier rigide, pour au moins un composant (18, 20), duquel émane au moins une section de contact (22) en forme de bande qui est orientée/orientable perpendiculairement à la section de support (21) par pliage du support du circuit (6) pour se situer dans le manchon de broche (2) du moins de manière essentiellement parallèle à la longueur du manchon de broche (2) et la section de support (21) présentant un diamètre extérieur qui est plus petit que le diamètre intérieur (D2) du manchon de broche (2).

9. Broche de contact selon la revendication 8, **caractérisée en ce que** la section de contact (22) présente, sur sa face latérale détournée de la face intérieure (15) du manchon de broche (2), au moins un circuit conducteur électroconducteur (9).

10. Broche de contact selon l'une des revendications précédentes, **caractérisée en ce que** le support de circuit (6), en particulier la section de contact (22), forme, sur une extrémité libre, en particulier non pliée/non roulée, une structure (32) pour un assemblage enfichable pour circuit imprimé.

11. Broche de contact selon l'une des revendications précédentes, **caractérisée en ce que** le support de circuit (6) présente au moins un premier chanfrein d'introduction (11) par lequel un enroulement du support de circuit (6) s'effectue ou du moins est facilité lors de l'insertion dans le manchon de broche (2).

12. Broche de contact selon l'une des revendications précédentes, **caractérisée en ce que** le manchon de broche (2) présente au moins un deuxième chanfrein d'introduction (22), en particulier un biseau, sur une extrémité axialement ouverte, par laquelle le support de circuit (6) est inséré/peut être inséré dans le manchon de broche (2).

13. Broche de contact selon l'une des revendications précédentes, **caractérisée en ce que** le support de circuit (6) présente, pour la formation d'une broche de contact de commutation ou d'un potentiomètre linéaire, au moins une piste de contact (26) dans l'extension longitudinale du manchon de broche (2), en particulier une piste de résistance (28), laquelle est connectable électriquement au moins dans une position coulissante de la tête d'essai (3) par rapport au manchon de broche (2) par un élément de contact (23) déplaçable dans le manchon de broche (2) par la tête d'essai (3).

14. Broche de contact selon l'une des revendications précédentes, **caractérisée en ce que** l'élément de contact (23) présente ou forme au moins un élément à ressort qui précontraint une surface de contact (25) de l'élément de contact (23) radialement pour entrer en contact avec la piste de contact (26).

15. Broche de contact selon l'une des revendications précédentes, **caractérisée en ce qu'**au moins un composant électrique/électronique (29) est conçu comme composant optoélectronique, ampoule, capteur et/ou résistance électrique.
